# EUROPEAN PATENT SPECIFICATION

(11) **EP 3 301 099 B1**
(45) Date of publication and mention of the grant of the patent: **28.04.2021**
(21) Application number: 17202119.8
(22) Date of filing: 21.02.2014
(51) Int. Cl.: C07F 15/00, C09K 11/87, H01L 51/50, H05B 33/14, C09K 11/06, H01L 51/00

(54) **PHOSPHORESCENT HOMOLEPTIC TRIS-[DEUTERATED-2-(2-PYRIDINYL)PHENYL]-IRIDIUM COMPLEXES FOR USE IN LIGHT-EMITTING DEVICES**
PHOSPHORESZIERENDE HOMOLEPTISCHE TRIS-[DEUTERIERTE-2-(2-PYRIDINYL)PHENYL]-IRIDIUM-KOMPLEXE UND DEREN VERWENDUNG IN LICHTEMITIERENDEN GEGENSTÄNDEN.
COMPLEXES PHOSPHORESCENTS HOMOLEPTIQUES TRIS- [DÉUTERÉS-2-(2-PYRIDINYL) PHÉNYL]-IRIDIUM DESTINÉS À ÊTRE UTILISÉS DANS DES DISPOSITIFS ÉLECTROLUMINESCENTS

(30) Priority: 21.02.2013 US 201361767508 P; 13.03.2013 US 201313798972; 22.04.2013 US 201313867750
(43) Date of publication of application: 04.04.2018
(62) Divisional of application: 14156167.0
(73) Proprietor: Universal Display Corporation, Ewing, NJ 08618 (US)
(72) Inventor: XIA, Chuanjun, Ewing, NJ New Jersey 08618 (US); ALLEYNE, Bert, Ewing, NJ New Jersey 08618 (US)
(74) Representative: Hansen, Norbert

(56) References cited:
- WO-A1-2006/095951
- WO-A1-2010/129323
- PING WANG, FEI-FEI WANG, YI CHEN, QIANG NIU, LEI LU, HONG-MING WANG, XI-CUN GAO, BIN WEI, HONG-WEI WU, XIN CAIC, DE-CHUN ZOU: "Synthesis of all-deuterated tris(2-phenylpyridine)iridium for highly stable electrophosphorescence: the deuterium effect", J. MATER. CHEM. C, vol. 1, 2 July 2013 (2013-07-02), pages 4821-4825, XP002725405, DOI: 10.1039/C3TC30547C

## Description

### CROSS-REFERENCE TO RELEATED APPLICATIONS

This application claims priority to U.S. Provisional Application Serial No. 61/767,508 filed February 21, 2013.

### PARTIES TO A JOINT RESEARCH AGREEMENT

The claimed invention was made by, on behalf of, and/or in connection with one or more of the following parties to a joint university corporation research agreement: Regents of the University of Michigan, Princeton University, University of Southern California, and the Universal Display Corporation. The agreement was in effect on and before the date the claimed invention was made, and the claimed invention was made as a result of activities undertaken within the scope of the agreement.

### FIELD OF THE INVENTION

The present invention relates to compounds for use as emitters and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)₃, which has the following structure:

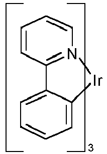

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704. WO 2010/129323 A1 discloses iridium complexes with methyl-d3 substitution. WO 2006/095951 A1 and Ping Wang et al., "Synthesis of all-deuterated tris(2 phenylpyridine) iridium for 5 highly stable electrophosphorescence: the deuterium effect,...". J. Mater, Chem. C, volume 1, 2013, pages 4821 to 4825 discuss the effect of replacing hydrogen by deuterium in iridium complexes.

### SUMMARY OF THE INVENTION

The present invention is directed to homoleptic, tris-iridium complexes including deuterated alkyl groups, an organic light emitting device and a formulation including them, and their use as defined in the claims.

### BRIEF DESCRIPTION OF THE DRAWINGS

The present disclosure is best understood from the following detailed description when read in conjunction with the accompanying drawing. It is emphasized that, according to common practice, the various features of the drawing are not necessarily to scale. On the contrary, the dimensions of the various features are arbitrarily expanded or reduced for clarity. Like numerals denote like features throughout the specification and drawings.
FIG. 1 shows an organic light emitting device.
FIG. 2 shows an inverted organic light emitting device that does not have a separate electron transport layer.

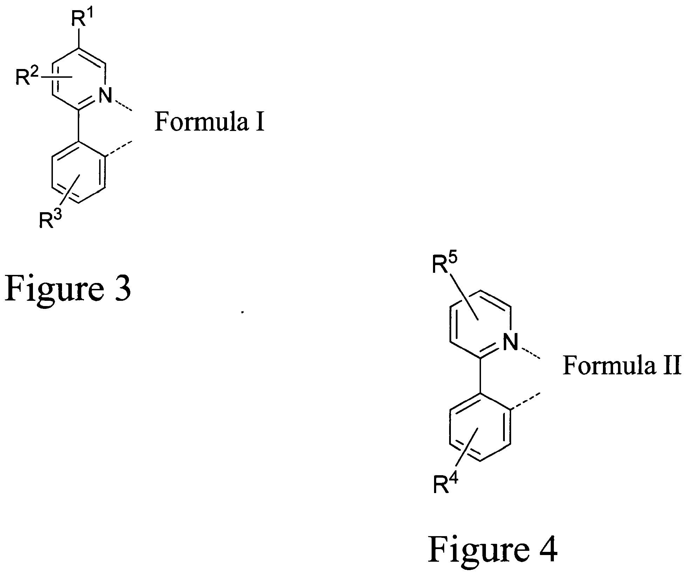

FIG. 3 shows Formula I as disclosed herein.
FIG. 4 shows Formula II as disclosed herein.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

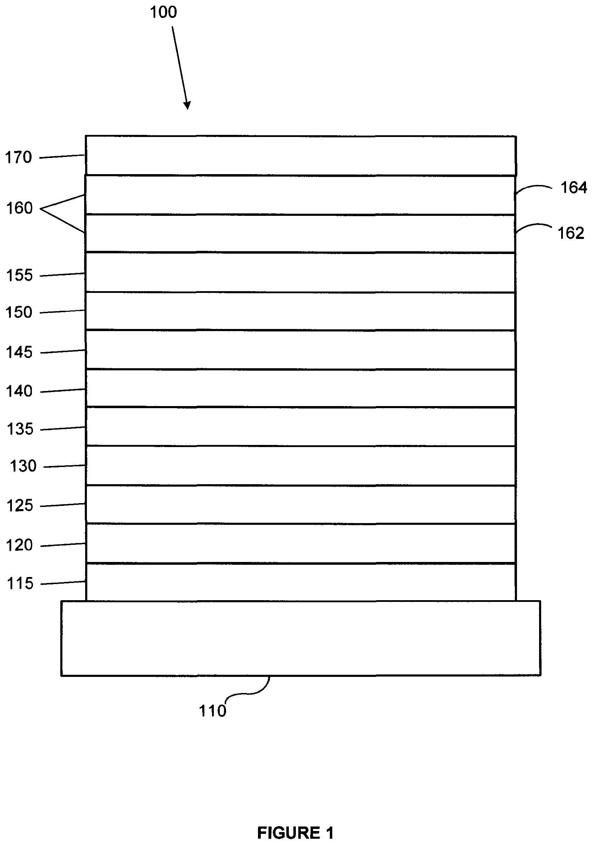

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

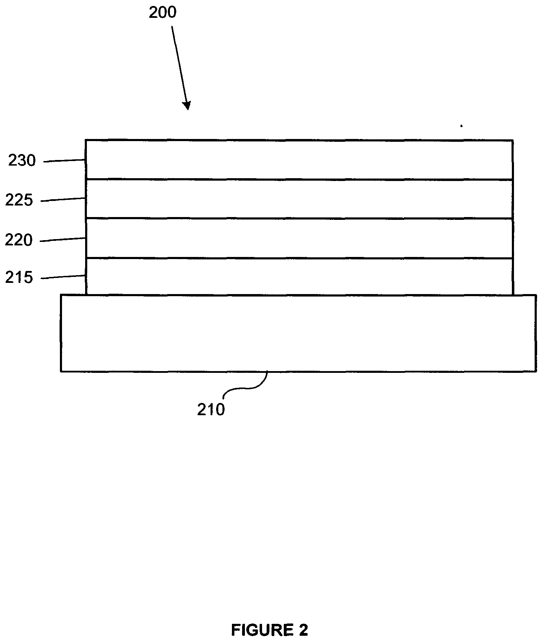

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention may be incorporated into a wide variety of consumer products, including flat panel displays, computer monitors, medical monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C.).

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The terms halo, halogen, alkyl, cycloalkyl, alkenyl, alkynyl, arylkyl, heterocyclic group, aryl, alkaryl, aromatic group, and heteroaryl are known to the art, and are defined in US 7,279,704 at cols. 31-32.

As used herein, "substituted" indicates that a substituent other than H is bonded to the relevant carbon. Thus, where R² is monosubstituted, then one R² must be other than H. Similarly, where R³ is disubstituted, the two of R³ must be other than H. Similarly, where R² is unsubstituted R² is hydrogen for all available positions.

According to an embodiment, heteroleptic iridium complexes are provided, which unexpectedly exhibit improved lifetime and make them more suitable for commercial applications. In particular, the heteroleptic complexes can be based on 2-phenylpyridine ligands that include a deuterated alkyl group in the 5^{th} position on the pyridine ring (*i.e.*, the para-position relative to the phenyl group). In addition, a number of homoleptic, tris-iridium complexes including deuterated alkyl groups that also exhibit unexpectedly improved lifetime were discovered.

According to one not claimed aspect, a heteroleptic iridium compound having the formula Ir(L¹)ₙ(L²)₃₋ₙ is provided. The first ligand L¹ has a structure according to Formula I: 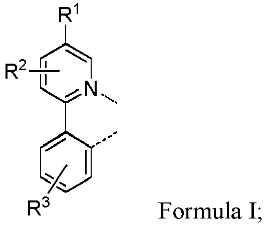 and the second ligand L² has a structure according to Formula II: 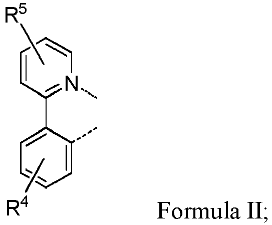
wherein L¹ is different from L²;
wherein R¹ is a partially or fully deuterated group consisting of alkyl and cyloalkyl;
wherein R² represents mono, di, tri substitutions or no substitution;
wherein R³, R⁴ and R⁵ each represent mono, di, tri, tetra substitutions or no substitution;
wherein R² and R³ are each independently selected from the group consisting of hydrogen, deuterium, alkyl, cycloalkyl, and combinations thereof;
wherein R⁴ and R⁵ are each independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and wherein n is 1 or 2

In some aspects, R¹ is a fully deuterated group selected from the group consisting of alkyl and cycloalkyl. More particularly, in some embodiments, R¹ is a fully deuterated group selected from the group consisting of methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, cyclohexyl.

In some aspects, the first ligand L¹ is selected from the group consisting of:

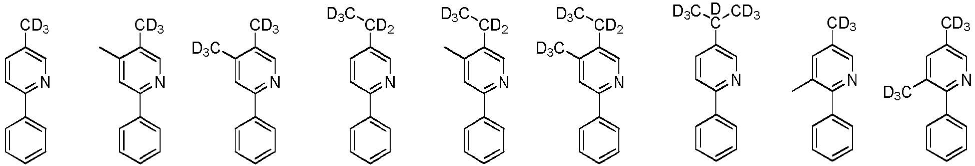

In some aspects, the second ligand L² is selected from the group consisting of: 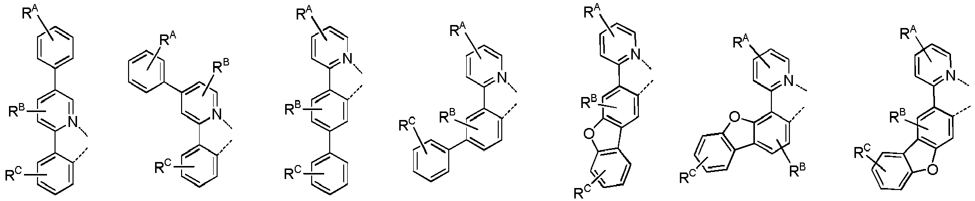 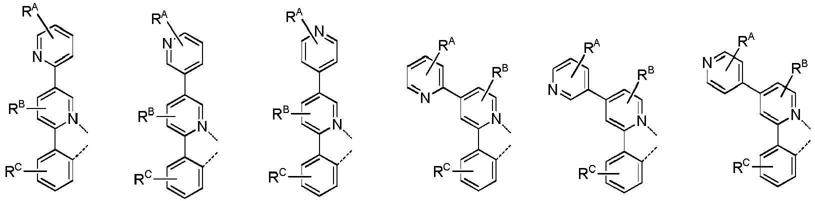
wherein R^{A}, and R^{C} each represent mono, di, tri, tetra substitutions or no substitution;
wherein R^{B} represents mono, di, tri substitutions or no substitution; and
wherein R^{A}, R^{B}, and R^{C} are independently selected from the group consisting of hydrogen, deuterium, methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclopentyl, cyclohexyl, and combinations thereof.

According to another aspect of the present disclosure, a first device is also provided. The first device includes a first organic light emitting device, that includes an anode, a cathode, and an organic layer disposed between the anode and the cathode. The organic layer can include a compound as defined in claim 1.

The first device can be one or more of a consumer product, an organic light-emitting device and a lighting panel. The organic layer can be an emissive layer and the compound can be an emissive dopant in some embodiments, while the compound can be a non-emissive dopant in other embodiments.

The organic layer can also include a host. In some embodiments, the host can include a metal complex. The host can be a triphenylene containing benzo-fused thiophene or benzo-fused furan. Any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, or no substitution. In the preceding substituents n can range from 1 to 10; and Ar₁ and Ar₂ can be independently selected from the group consisting of benzene, biphenyl, naphthalene, triphenylene, carbazole, and heteroaromatic analogs thereof.

The host can be a compound selected from the group consisting of carbazole, dibenzothiphene, dibenzofuran, dibenzoselenophene, azacarbazole, aza-dibenzothiophene, aza-dibenzofuran, and aza-dibenzoselenophene. The "aza" designation in the fragments described above, i.e., aza-dibenzofuran, aza-dibenzothiophene, etc., means that one or more of the C-H groups in the respective fragment can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein. The host can include a metal complex. The host can be a specific compound selected from the group consisting of: 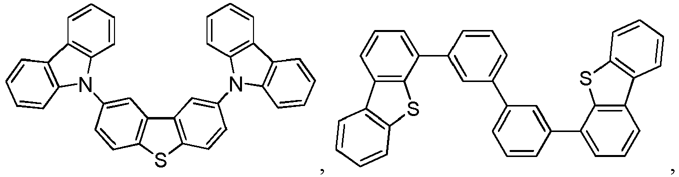 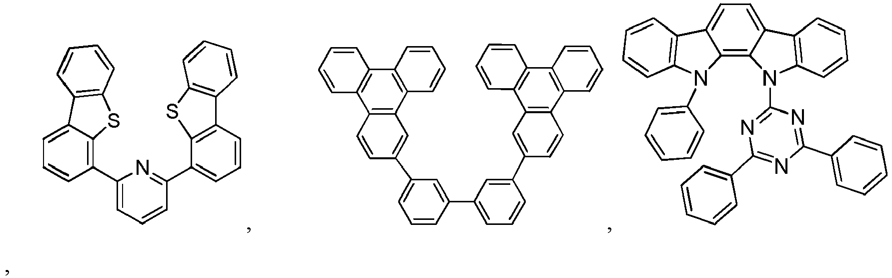 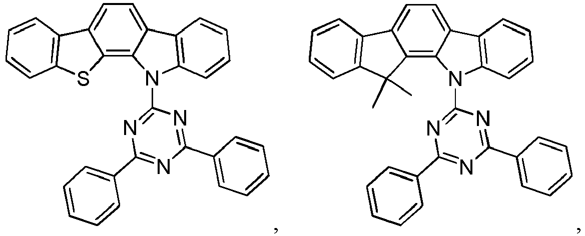 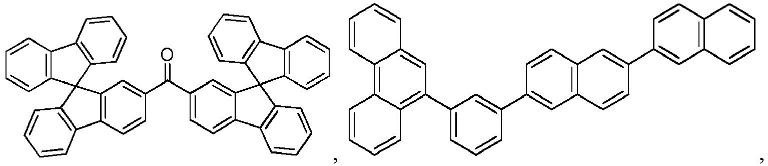 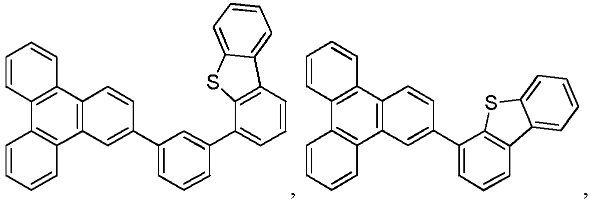 and combinations thereof.

In yet another aspect of the present disclosure, a formulation that includes a compound as defined in claim 1 is described. The formulation can include one or more components selected from the group consisting of a solvent, a host, a hole injection material, hole transport material, an electron transport layer material (see below).

The present invention is directed to homoleptic, tris-iridium complexes including deuterated alkyl groups. The tris-iridium complexes are selected from the group consisting of:

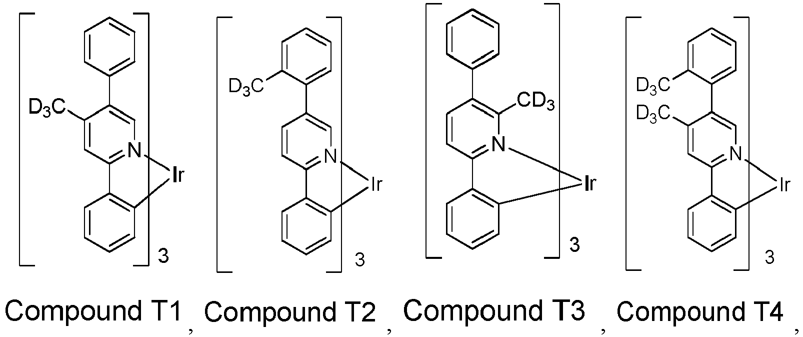

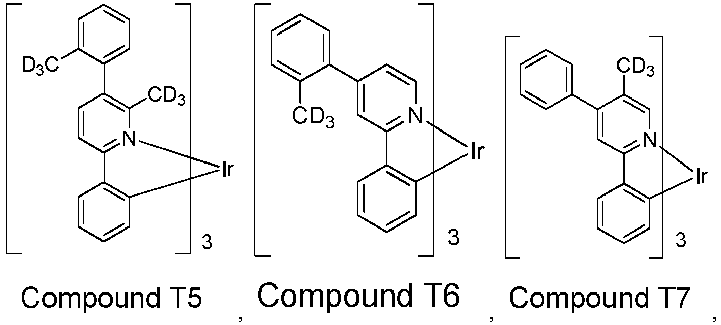

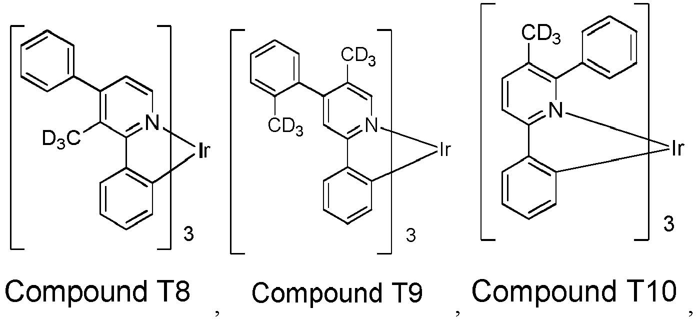

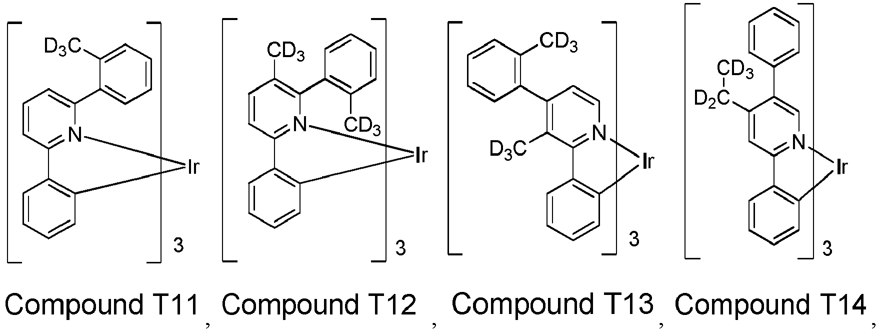

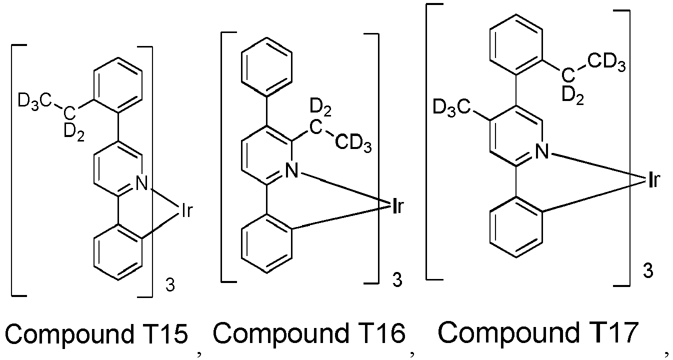

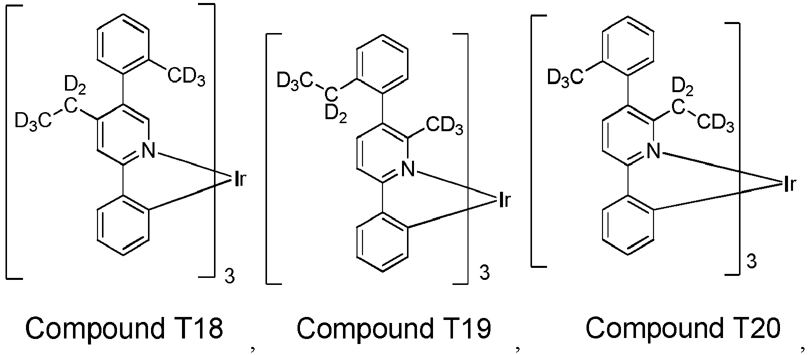

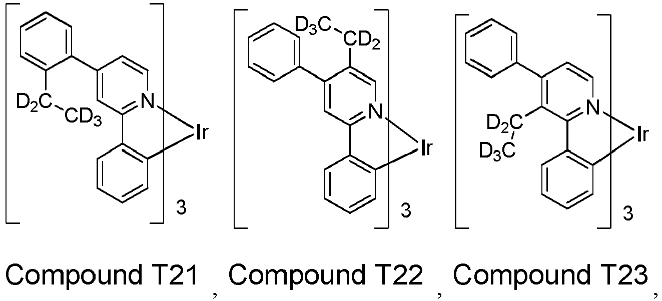

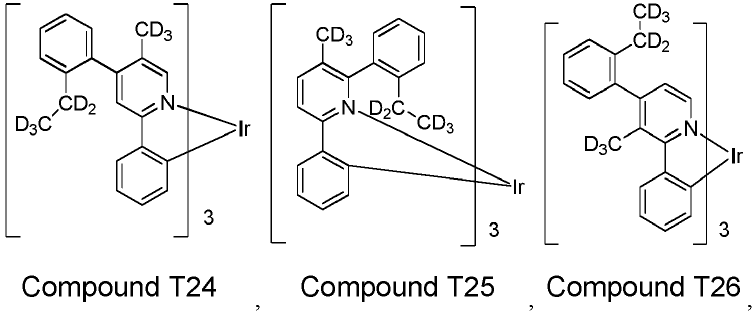

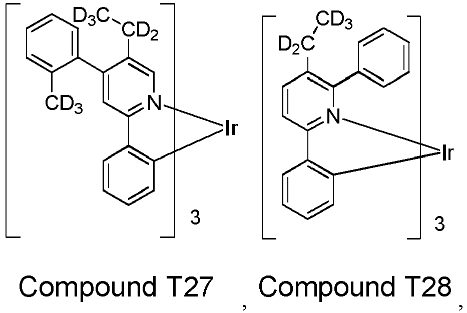

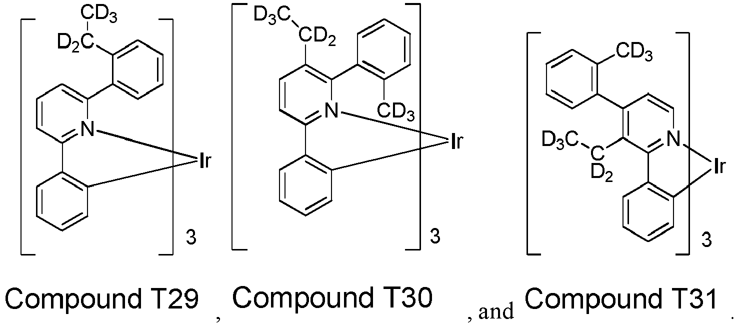

According to yet another embodiment of the present disclosure, a first device is also provided. The first device includes a first organic light emitting device, that includes an anode, a cathode, and an organic layer disposed between the anode and the cathode. The organic layer can include a homoleptic, tris-iridium complex. The homoleptic, tris-iridium complex is selected from the group consisting of:

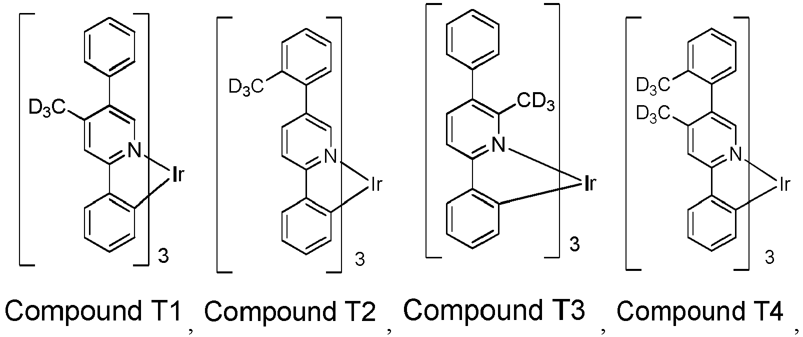

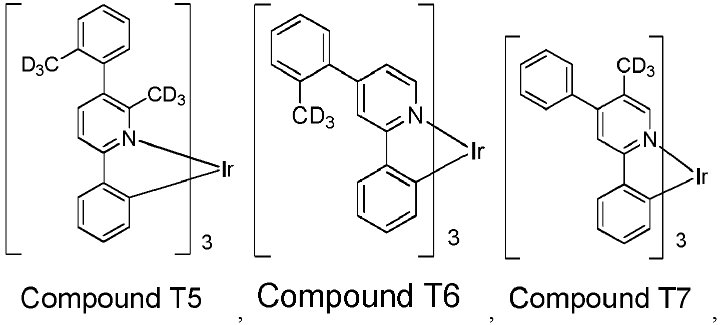

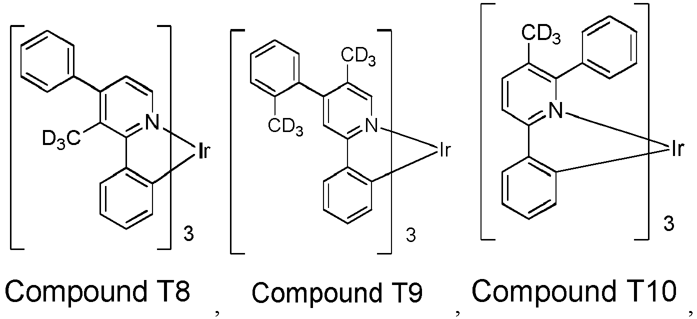

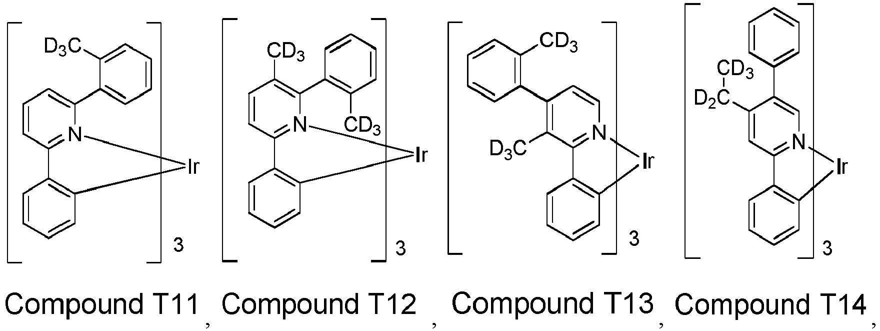

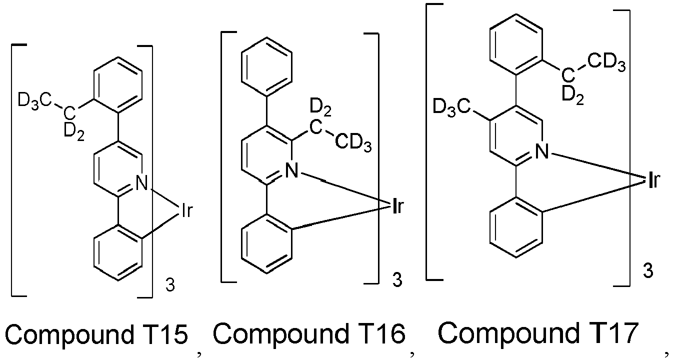

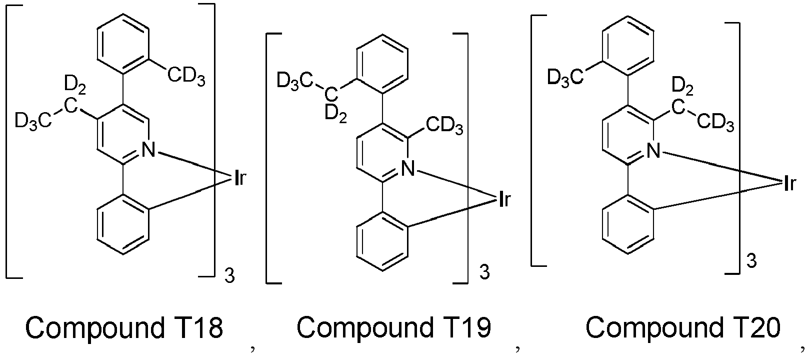

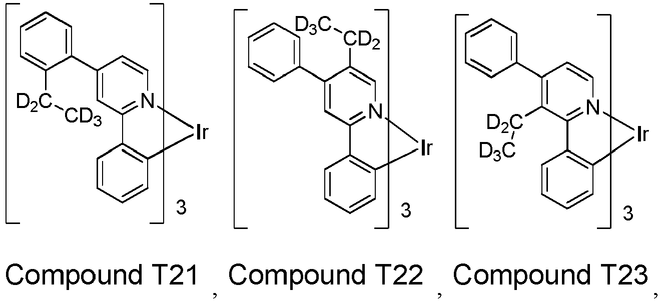

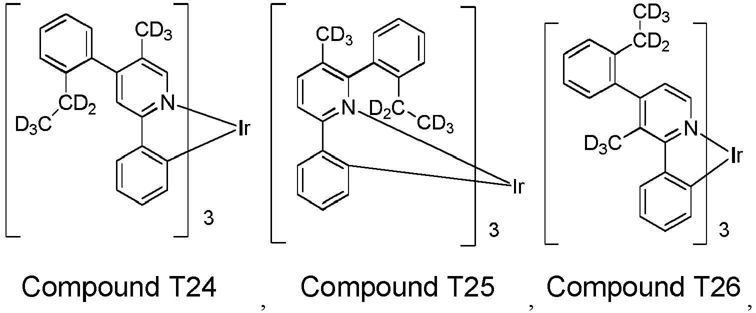

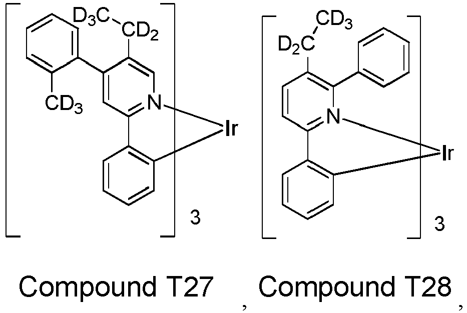

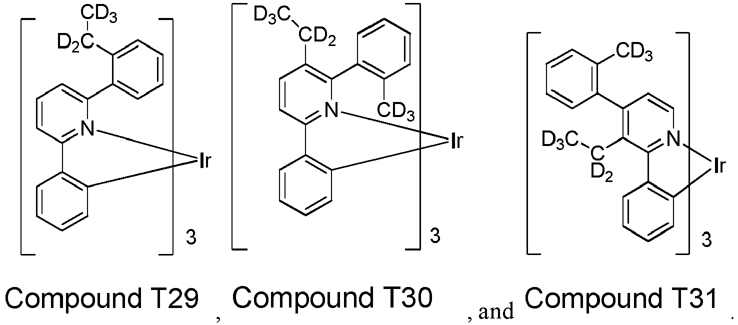

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### HIL/HTL:

A hole injecting/transporting material to be used in the present invention is not particularly limited, and any compound may be used as long as the compound is typically used as a hole injecting/transporting material. Examples of the material include, but not limit to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

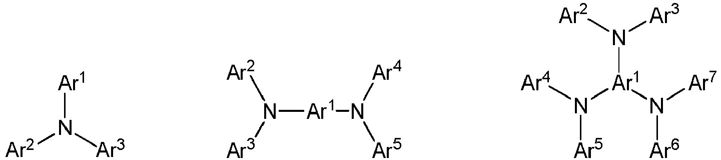

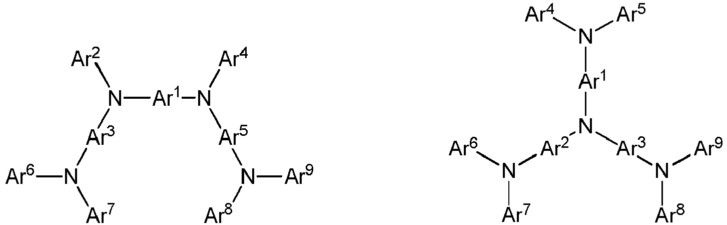

Each of Ar¹ to Ar⁹ is selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each Ar is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of:

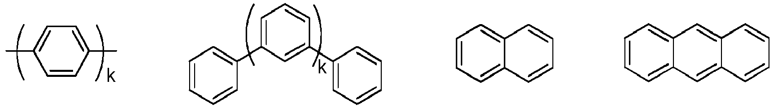

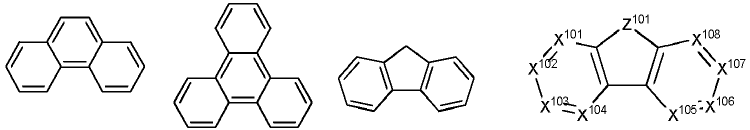

k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but not limit to the following general formula:

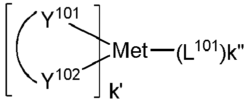

Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. While the Table below categorizes host materials as preferred for devices that emit various colors, any host material may be used with any dopant so long as the triplet criteria is satisfied.

Examples of metal complexes used as host are preferred to have the following general formula:

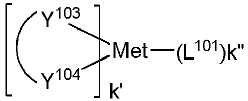

Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are:

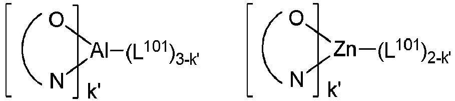

(O-N) is a bidentate ligand, having metal coordinated to atoms O and N. In another aspect, Met is selected from Ir and Pt. In a further aspect, (Y¹⁰³-Y¹⁰⁴) is a carbene ligand.

Examples of organic compounds used as host are selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each group is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, host compound contains at least one of the following groups in the molecule:

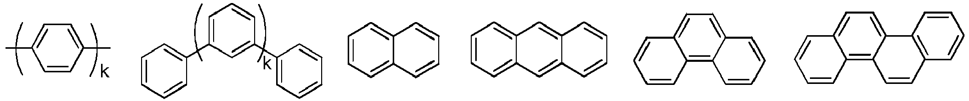

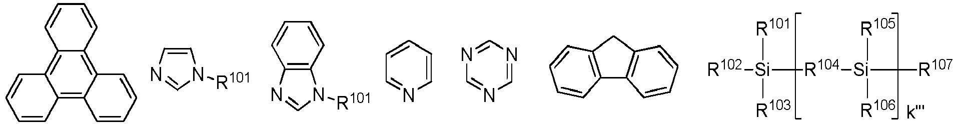

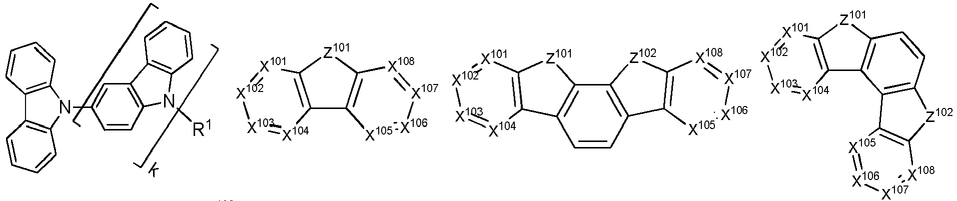

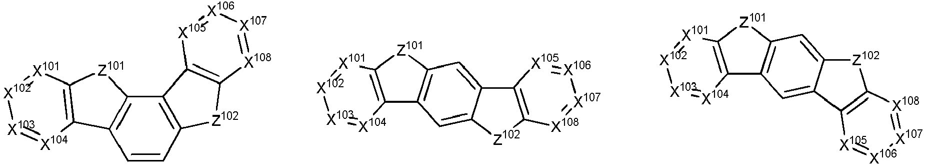

R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

k is an integer from 0 to 20 or 1 to 20; k"' is an integer from 0 to 20. X¹⁰¹ to X¹⁰⁸ is selected from C (including CH) or N. Z¹⁰¹ and Z¹⁰² is selected from NR¹⁰¹, O, or S.

### HBL:

A hole blocking layer (HBL) may be used to reduce the number of holes and/or excitons that leave the emissive layer. The presence of such a blocking layer in a device may result in substantially higher efficiencies as compared to a similar device lacking a blocking layer. Also, a blocking layer may be used to confine emission to a desired region of an OLED.

In one aspect, compound used in HBL contains the same molecule or the same functional groups used as host described above.

In another aspect, compound used in HBL contains at least one of the following groups in the molecule:

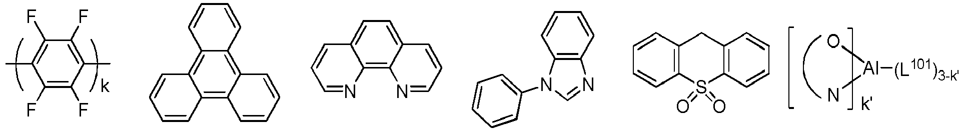

k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule:

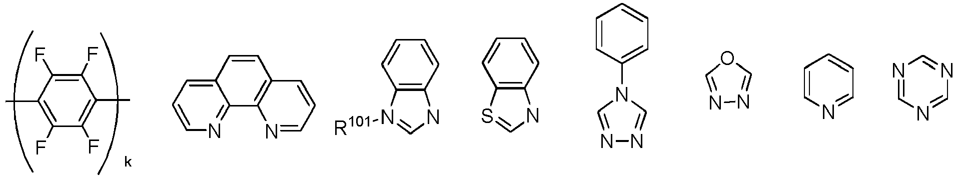

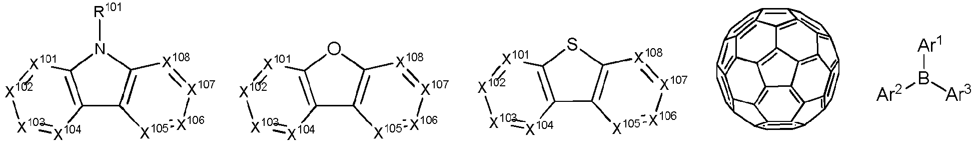

R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above.

Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula:

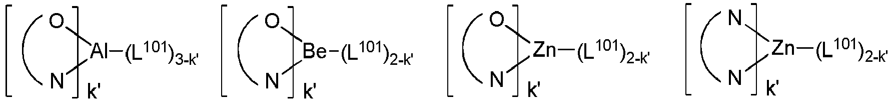

(O-N) or (N-N) is a bidentate ligand, having metal coordinated to atoms O, N or N, N; L¹⁰¹ is another ligand; k' is an integer value from 1 to the maximum number of ligands that may be attached to the metal.

In any above-mentioned compounds used in each layer of the OLED device, the hydrogen atoms can be partially or fully deuterated. Thus, any specifically listed substituent, such as, without limitation, methyl, phenyl, pyridyl, etc. encompasses undeuterated, partially deuterated, and fully deuterated versions thereof. Similarly, classes of substituents such as, without limitation, alkyl, aryl, cycloalkyl, heteroaryl, etc. also encompass undeuterated, partially deuterated, and fully deuterated versions thereof.

In addition to and / or in combination with the materials disclosed herein, many hole injection materials, hole transporting materials, host materials, dopant materials, exciton/hole blocking layer materials, electron transporting and electron injecting materials may be used in an OLED. Non-limiting examples of the materials that may be used in an OLED in combination with materials disclosed herein are listed in Table 1 below. Table 1 lists non-limiting classes of materials, non-limiting examples of compounds for each class, and references that disclose the materials.

**TABLE 1**

| **MATERIAL** | **EXAMPLES OF MATERIAL** | **PUBLICATIONS** |
|---|---|---|
| **Hole injection materials** | | |
| Phthalocyanine and porphyrin compounds | 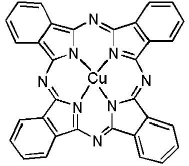 | Appl. Phys. Lett. 69, 2160 (1996) |
| Starburst triarylamines | 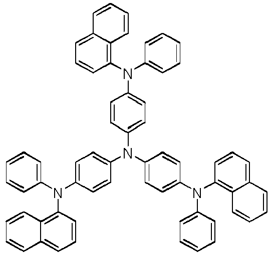 | J. Lumin. 72-74, 985 (1997) |
| CF_{X} Fluorohydrocarbon polymer | 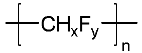 | Appl. Phys. Lett. 78, 673 (2001) |
| Conducting polymers (e.g., PEDOT:PSS, polyaniline, polythiophene) | 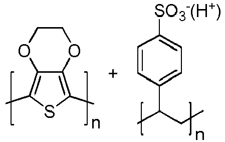 | Synth. Met. 87, 171 (1997) WO2007002683 |
| Phosphonic acid and silane SAMs | 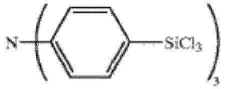 | US20030162053 |
| Triarylamine or polythiophene polymers with conductivity dopants | 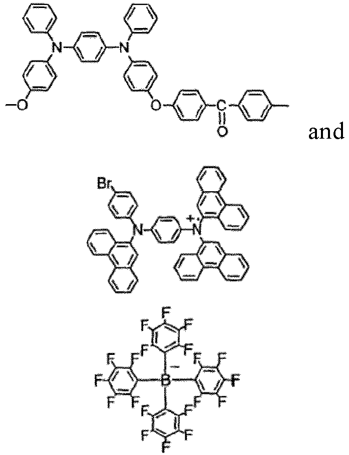 | EP1725079A1 |
| Organic compounds with conductive inorganic compounds, such as molybdenum and tungsten oxides | 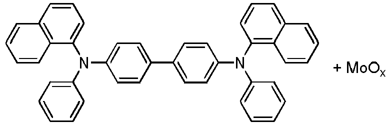 | US20050123751 SID Symposium Digest, 37, 923 (2006) WO2009018009 |
| n-type semiconducting organic complexes | | US20020158242 |
| Metal organometallic complexes | | US20060240279 |
| Cross-linkable compounds | | US20080220265 |
| Polythiophene based polymers and copolymers | 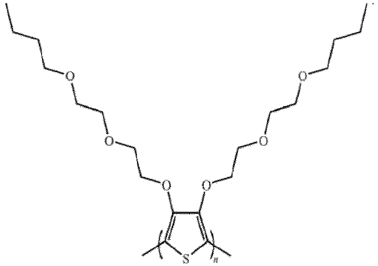 | WO 2011075644 EP2350216 |

| **Hole transporting materials** | | |
|---|---|---|
| Triarylamines (e.g., TPD, α-NPD) | 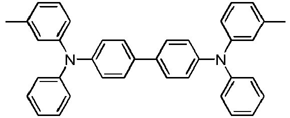 | Appl. Phys. Lett. 51, 913 (1987) |
| | 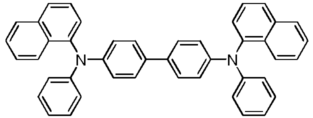 | US5061569 |
| | 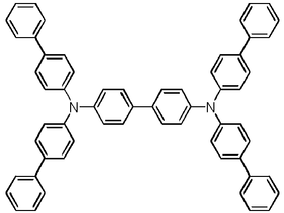 | EP650955 |
| | 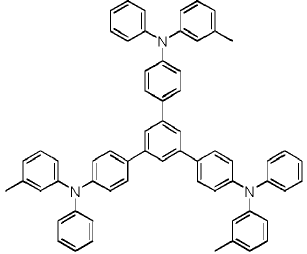 | J. Mater. Chem. 3, 319 (1993) |
| | 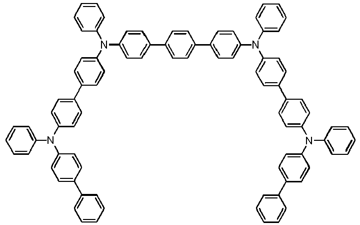 | Appl. Phys. Lett. 90, 183503 (2007) |
| | 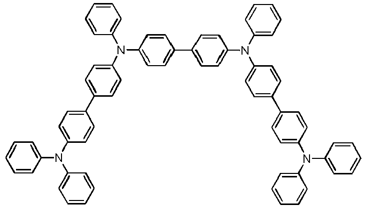 | Appl. Phys. Lett. 90, 183503 (2007) |
| Triarylamine on spirofluorene core | 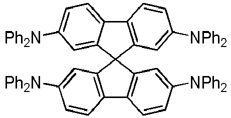 | Synth. Met. 91, 209 (1997) |
| Arylamine carbazole compounds | 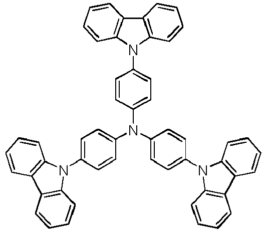 | Adv. Mater. 6, 677 (1994), US20080124572 |
| Triarylamine with (di)benzothiophene/(di)ben zofuran | 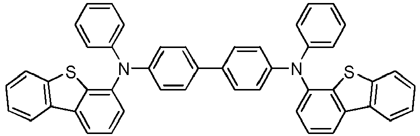 | US20070278938, US20080106190 US20110163302 |
| Indolocarbazoles | 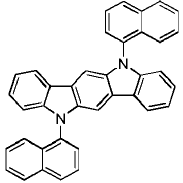 | Synth. Met. 111, 421 (2000) |
| Isoindole compounds | 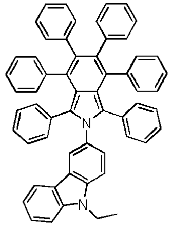 | Chem. Mater. 15, 3148 (2003) |
| Metal carbene complexes | 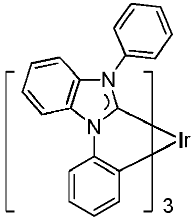 | US20080018221 |

| **Phosphorescent OLED host materials** | | |
|---|---|---|
| **Red hosts** | | |
| Arylcarbazoles | 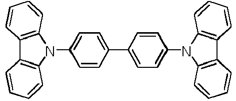 | Appl. Phys. Lett. 78, 1622 (2001) |
| Metal 8-hydroxyquinolates (e.g., Alq₃, BAlq) | 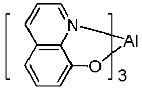 | Nature 395, 151 (1998) |
| | 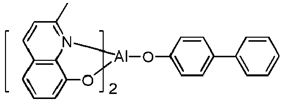 | US20060202194 |
| | 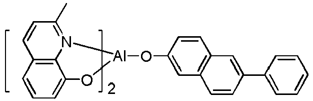 | WO2005014551 |
| | 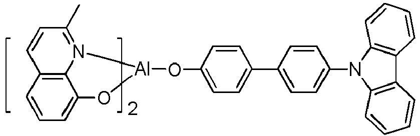 | WO2006072002 |
| Metal phenoxybenzothiazole compounds | 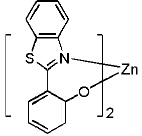 | Appl. Phys. Lett. 90, 123509 (2007) |
| Conjugated oligomers and polymers (e.g., polyfluorene) | 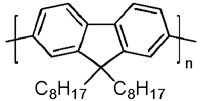 | Org. Electron. 1, 15 (2000) |
| Aromatic fused rings | 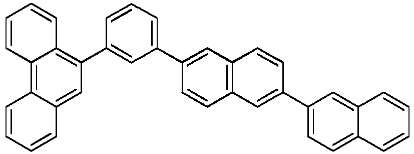 | WO2009066779, WO2009066778, WO2009063 833, US20090045731, US20090045730, WO2009008311, US20090008605, US20090009065 |
| Zinc complexes | 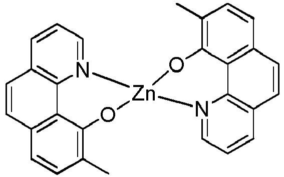 | WO2010056066 |
| Chrysene based compounds | 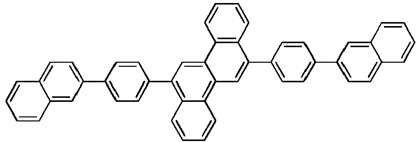 | WO2011086863 |

| **Green hosts** | | |
|---|---|---|
| Arylcarbazoles | 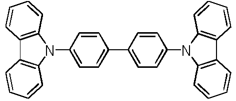 | Appl. Phys. Lett. 78, 1622 (2001) |
| | 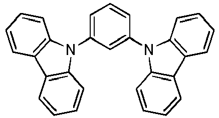 | US20030175553 |
| | 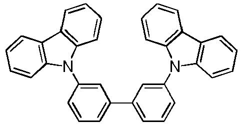 | WO2001039234 |
| Aryltriphenylene compounds | 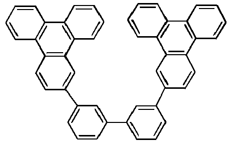 | US20060280965 |
| | 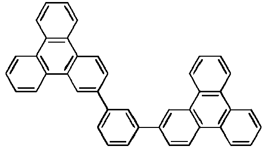 | US20060280965 |
| | 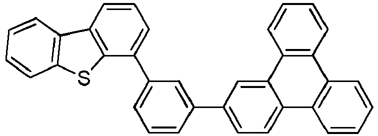 | WO2009021126 |
| Poly-fused heteroaryl compounds | 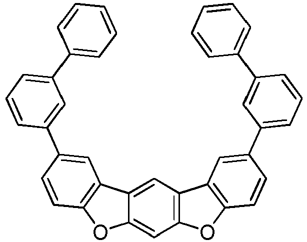 | US20090309488 US20090302743 US20100012931 |
| | | |
| Donor acceptor type molecules | 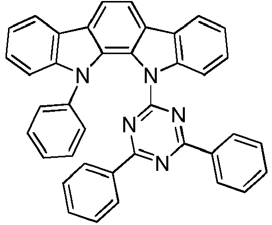 | WO2008056746 |
| | 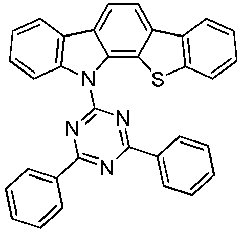 | WO2010107244 |
| Aza-carbazole/DBT/DBF | 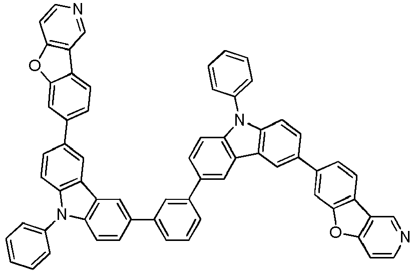 | JP2008074939 |
| | 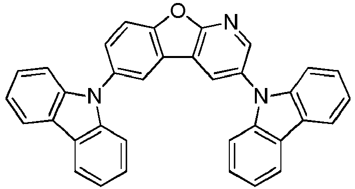 | US20100187984 |
| Polymers (e.g., PVK) | 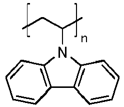 | Appl. Phys. Lett. 77, 2280 (2000) |
| Spirofluorene compounds | 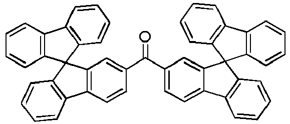 | WO2004093207 |
| Metal phenoxybenzooxazole compounds | 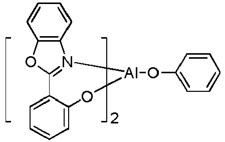 | WO2005089025 |
| | 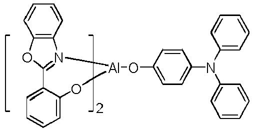 | WO2006132173 |
| | 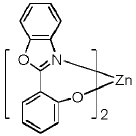 | JP200511610 |
| Spirofluorene-carbazole compounds | 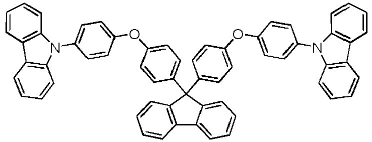 | JP2007254297 |
| | 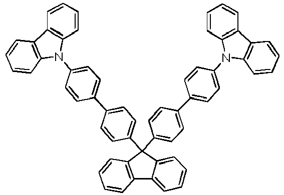 | JP2007254297 |
| Indolocarbazoles | 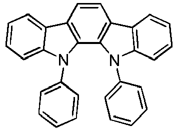 | WO2007063796 |
| | 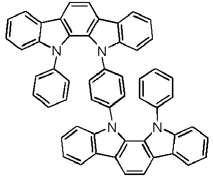 | WO2007063754 |
| 5-memberring electron deficient heterocycles (e.g., triazole, oxadiazole) | 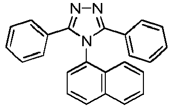 | J. Appl. Phys. 90, 5048 (2001) |
| | 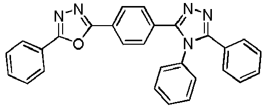 | WO2004107822 |
| Tetraphenylene complexes | 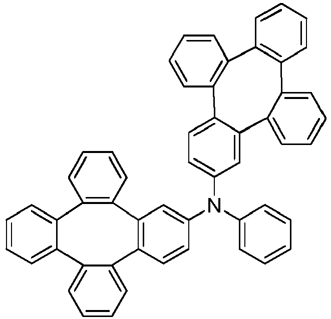 | US20050112407 |
| Metal phenoxypyridine compounds | 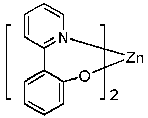 | WO2005030900 |
| Metal coordination complexes (e.g., Zn, Al with N^N ligands) | 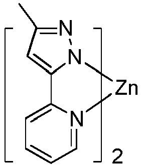 | US20040137268, US20040137267 |

| **Blue hosts** | | |
|---|---|---|
| Arylcarbazoles | 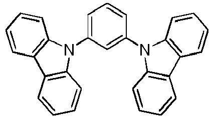 | Appl. Phys. Lett, 82, 2422(2003) |
| | 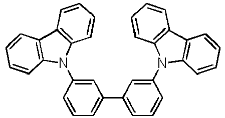 | US20070190359 |
| Dibenzothiophene/Dibenz ofuran-carbazole compounds | 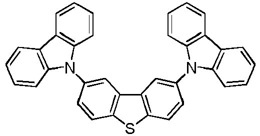 | WO2006114966, US20090167162 |
| | 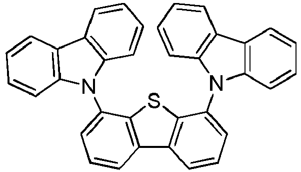 | US20090167162 |
| | 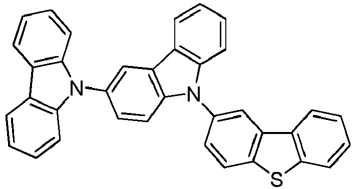 | WO2009086028 |
| | 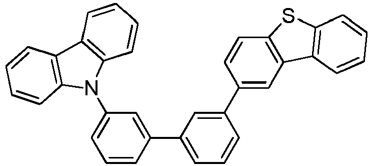 | US20090030202, US20090017330 |
| | 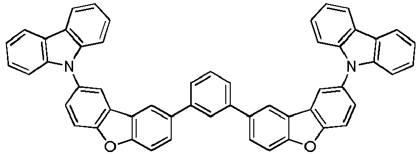 | US20100084966 |
| Silicon aryl compounds | 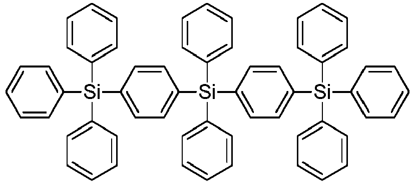 | US20050238919 |
| | 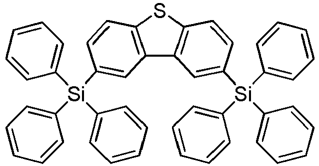 | WO2009003 898 |
| Silicon/Germanium aryl compounds | 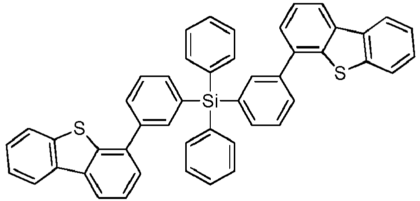 | EP2034538A |
| Aryl benzoyl ester | 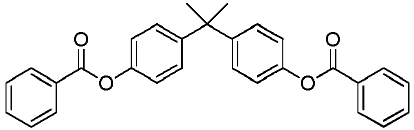 | WO2006100298 |
| Carbazole linked by nonconjugated groups | 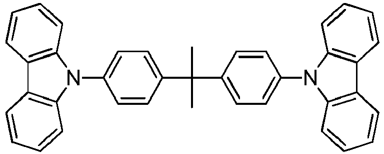 | US20040115476 |
| Aza-carbazoles | 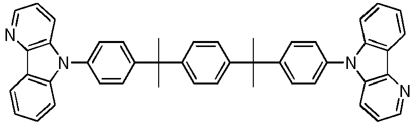 | US20060121308 |
| High triplet metal organometallic complex | 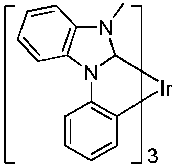 | US7154114 |

| **Phosphorescent dopants** | | |
|---|---|---|
| **Red dopants** | | |
| Heavy metal porphyrins (e.g., PtOEP) | 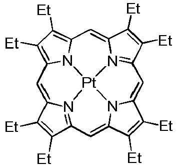 | Nature 395, 151 (1998) |
| Iridium(III) organometallic complexes | 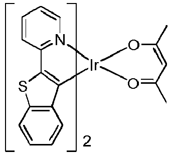 | Appl. Phys. Lett. 78, 1622 (2001) |
| | 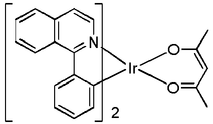 | US2006835469 |
| | 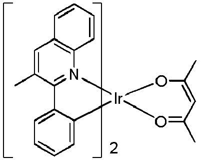 | US2006835469 |
| | 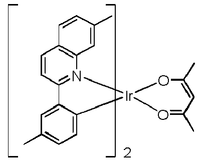 | US20060202194 |
| | 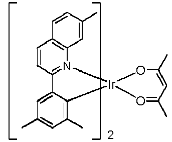 | US20060202194 |
| | 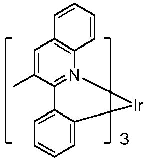 | US20070087321 |
| | 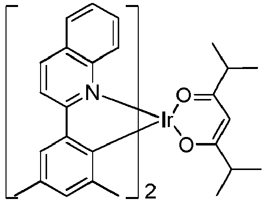 | US20080261076 US20100090591 |
| | 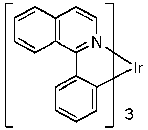 | US20070087321 |
| | 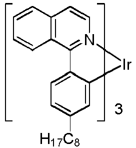 | Adv. Mater. 19, 739 (2007) |
| | 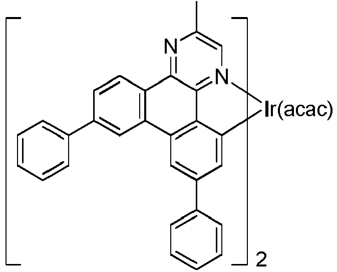 | WO2009100991 |
| | 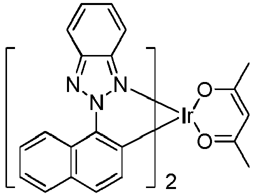 | WO2008101842 |
| | 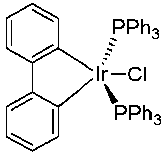 | US7232618 |
| Platinum(II) organometallic complexes | 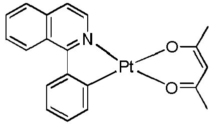 | WO2003040257 |
| | 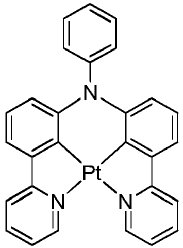 | US20070103060 |
| Osmium(III) complexes | 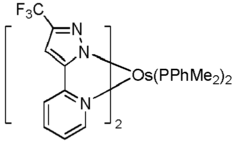 | Chem. Mater. 17, 3532 (2005) |
| Ruthenium(II) complexes | 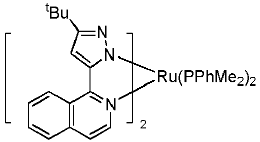 | Adv. Mater. 17, 1059 (2005) |
| Rhenium (I), (II), and (III) complexes | | US20050244673 |

| **Green dopants** | | |
|---|---|---|
| Iridium(III) organometallic complexes | 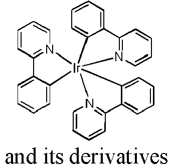 | Inorg. Chem. 40, 1704 (2001) |
| | 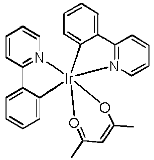 | US20020034656 |
| | 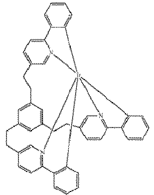 | US7332232 |
| | | US20090108737 |
| | | WO2010028151 |
| | 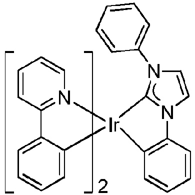 | EP1841834B |
| | 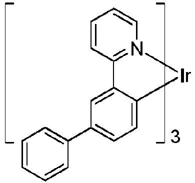 | US20060127696 |
| | 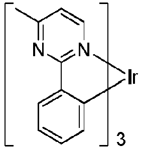 | US20090039776 |
| | 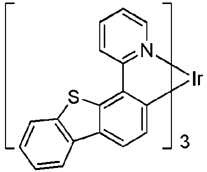 | US6921915 |
| | 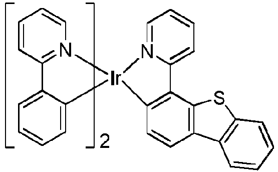 | US20100244004 |
| | 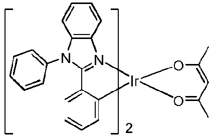 | US6687266 |
| | 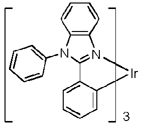 | Chem. Mater. 16, 2480 (2004) |
| | 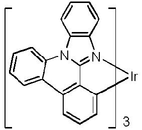 | US20070190359 |
| | 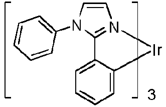 | US 20060008670 JP2007123392 |
| | 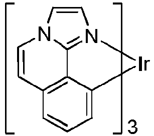 | WO2010086089, WO2011044988 |
| | 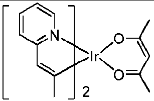 | Adv. Mater. 16, 2003 (2004) |
| | 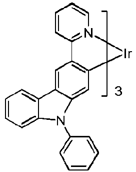 | Angew. Chem. Int. Ed. 2006, 45, 7800 |
| | 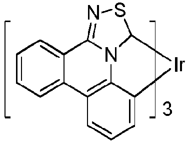 | WO2009050290 |
| | 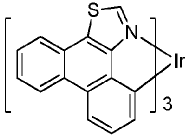 | US20090165846 |
| | 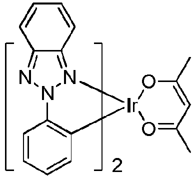 | US20080015355 |
| | 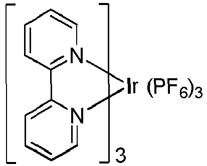 | US20010015432 |
| | 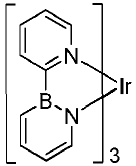 | US20100295032 |
| Monomer for polymeric metal organometallic compounds | 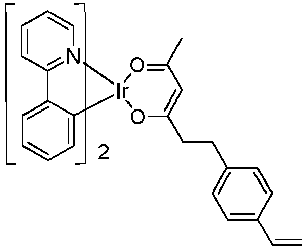 | US7250226, US7396598 |
| Pt(II) organometallic complexes, including polydentate ligands | 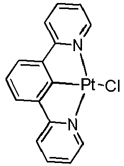 | Appl. Phys. Lett. 86, 153505 (2005) |
| | 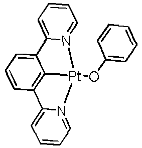 | Appl. Phys. Lett. 86, 153505 (2005) |
| | 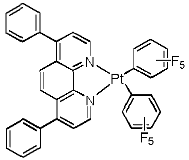 | Chem. Lett. 34, 592 (2005) |
| | 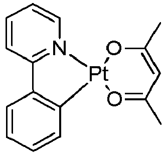 | WO2002015645 |
| | 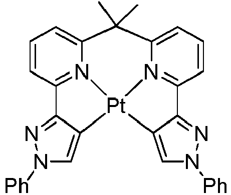 | US20060263635 |
| | 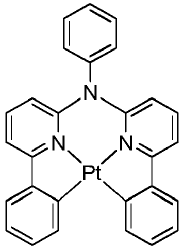 | US20060182992 US20070103060 |
| Cu complexes | 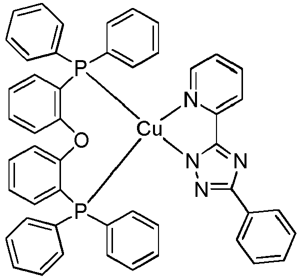 | WO2009000673 |
| | 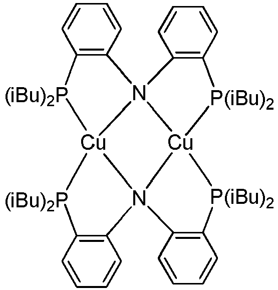 | US20070111026 |
| Gold complexes | 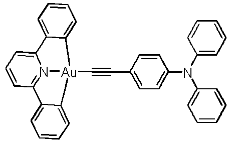 | Chem. Commun. 2906 (2005) |
| Rhenium(III) complexes | 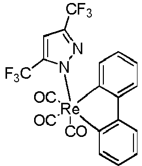 | Inorg. Chem. 42, 1248 (2003) |
| Osmium(II) complexes | | US7279704 |
| Deuterated organometallic complexes | | US20030138657 |
| Organometallic complexes with two or more metal centers | | US20030152802 |
| | 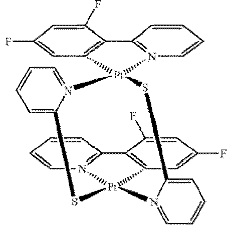 | US7090928 |

| **Blue dopants** | | |
|---|---|---|
| Iridium(III) organometallic complexes | 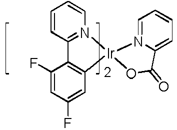 | WO2002002714 |
| | 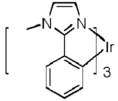 | WO2006009024 |
| | 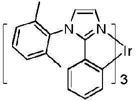 | US20060251923 US20110057559 US20110204333 |
| | 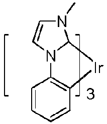 | US7393599, WO2006056418, US20050260441, WO2005019373 |
| | 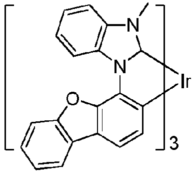 | US7534505 |
| | 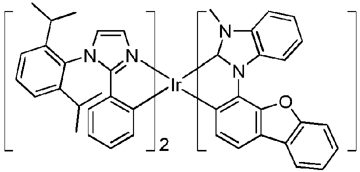 | WO2011051404 |
| | 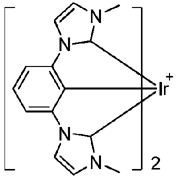 | US7445855 |
| | 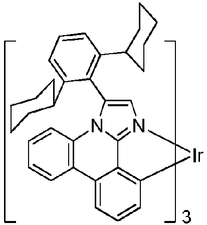 | US20070190359, US20080297033 US20100148663 |
| | 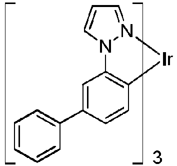 | US7338722 |
| | 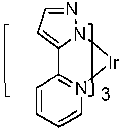 | US20020134984 |
| | 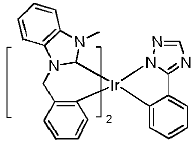 | Angew. Chem. Int. Ed. 47, 1 (2008) |
| | 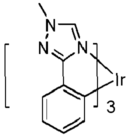 | Chem. Mater. 18, 5119 (2006) |
| | 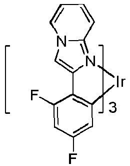 | Inorg. Chem. 46, 4308 (2007) |
| | 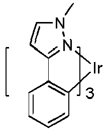 | WO2005123873 |
| | 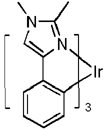 | WO2005123873 |
| | 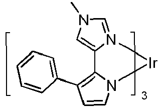 | WO2007004380 |
| | 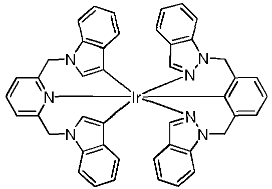 | WO2006082742 |
| Osmium(II) complexes | 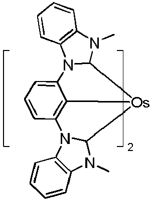 | US7279704 |
| | 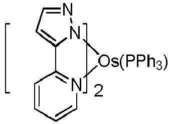 | Organometallics 23, 3745 (2004) |
| Gold complexes | 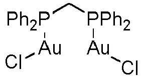 | Appl. Phys. Lett.74,1361 (1999) |
| Platinum(II) complexes | 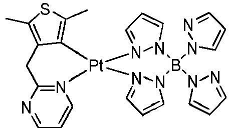 | WO2006098120, WO2006103 874 |
| Pt tetradentate complexes with at least one metal-carbene bond | 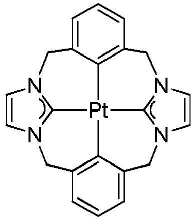 | US7655323 |

| **Exciton/hole blocking layer materials** | | |
|---|---|---|
| Bathocuprine compounds (e.g., BCP, BPhen) | 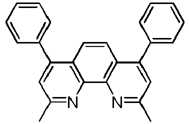 | Appl. Phys. Lett. 75, 4 (1999) |
| | 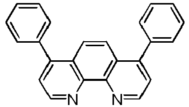 | Appl. Phys. Lett. 79, 449 (2001) |
| Metal 8-hydroxyquinolates (e.g., BAlq) | 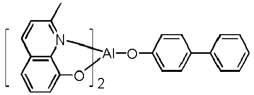 | Appl. Phys. Lett. 81, 162 (2002) |
| 5-member ring electron deficient heterocycles such as triazole, oxadiazole, imidazole, benzoimidazole | 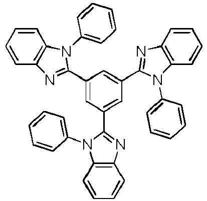 | Appl. Phys. Lett. 81, 162 (2002) |
| Triphenylene compounds | 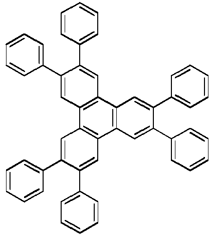 | US20050025993 |
| Fluorinated aromatic compounds | 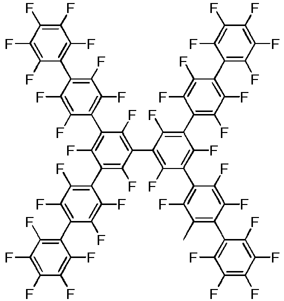 | Appl. Phys. Lett. 79, 156(2001) |
| Phenothiazine-S -oxide | 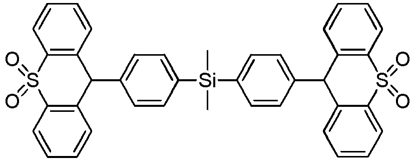 | WO2008132085 |
| Silylated five-membered nitrogen, oxygen, sulfur or phosphorus dibenzoheterocycles | 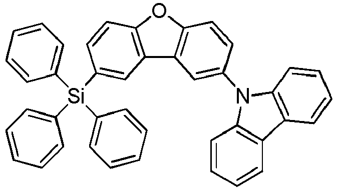 | WO2010079051 |
| Aza-carbazoles | 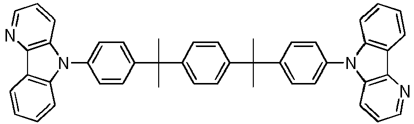 | US20060121308 |

| **Electron transporting materials** | | |
|---|---|---|
| Anthracene-benzoimidazole compounds | 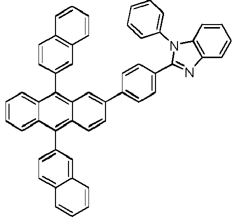 | WO2003060956 |
| | | US20090179554 |
| Aza triphenylene derivatives | 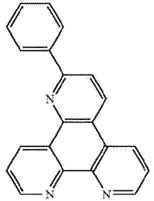 | US20090115316 |
| Anthracene- benzothiazole compounds | 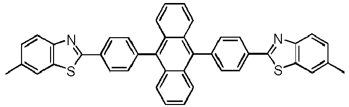 | Appl. Phys. Lett. 89, 063504 (2006) |
| Metal 8-hydroxyquinolates (e.g., Alq₃, Zrq₄) | 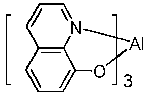 | Appl. Phys. Lett. 51, 913 (1987) US7230107 |
| Metal hydroxybenzoquinolates | 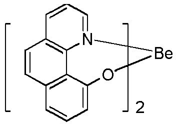 | Chem. Lett. 5, 905 (1993) |
| Bathocuprine compounds such as BCP, BPhen, etc | 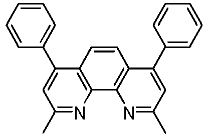 | Appl. Phys. Lett. 91, 263503 (2007) |
| | 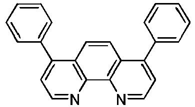 | Appl. Phys. Lett. 79, 449 (2001) |
| 5-member ring electron deficient heterocycles (e.g., triazole, oxadiazole, imidazole, benzoimidazole) | 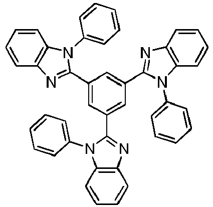 | Appl. Phys. Lett. 74, 865 (1999) |
| | 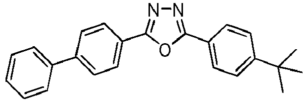 | Appl. Phys. Lett. 55, 1489 (1989) |
| | 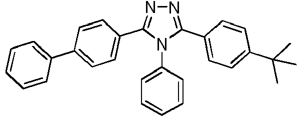 | Jpn. J. Apply. Phys. 32, L917 (1993) |
| Silole compounds | 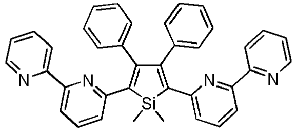 | Org. Electron. 4, 113 (2003) |
| Arylborane compounds | 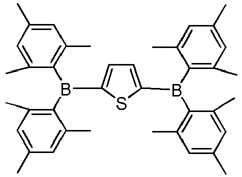 | J. Am. Chem. Soc. 120, 9714 (1998) |
| Fluorinated aromatic compounds | 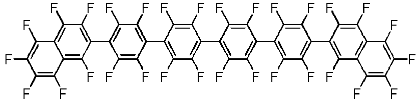 | J. Am. Chem. Soc. 122, 1832 (2000) |
| Fullerene (e.g., C60) | 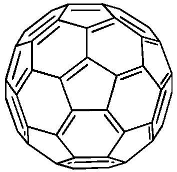 | US20090101870 |
| Triazine complexes | 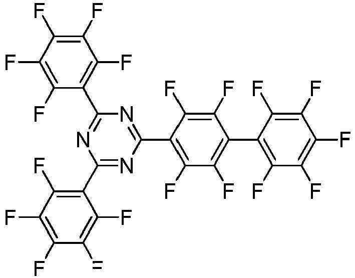 | US20040036077 |
| Zn (N^N) complexes | 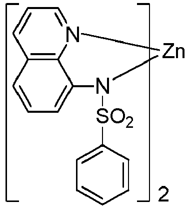 | US6528187 |

### EXPERIMENTAL

### Synthesis of Compound 2 (not claimed)

**Synthesis of iridium dimer.** To a 500 mL round bottom flask was added iridium chloride hydrate (5.16 g, 14.65 mmol), 5-(Methyl-*d3*)-2-phenylpyridine (5.55 g, 32.2 mmol), 120 mL 2-ethoxyethanol, and 40 mL water. Nitrogen was bubbled into the mixture, which was then heated at 130 °C overnight under nitrogen.

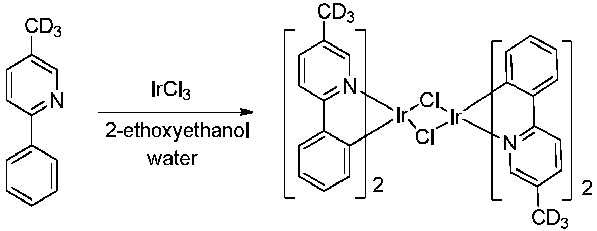

After being heated for 2 days, the reaction mixture was cooled to room temperature. A yellow solid was filtered off and washed with methanol and dried to obtain iridium chloro-bridged dimer (7.24 g, 87%).

**Synthesis of iridium (III) triflate intermediate.** To a 1L round bottom flask was added the iridium chloro-bridged dimer (7.24 g, 6.35 mmol) and 600 mL dichloromethane. To this solution a solution of silver triflate (3.43 g, 13.33 mmol) in 100 mL methanol was added. An additional 100 mL of dichloromethane was added and the reaction allowed proceeding overnight at room temperature under nitrogen.

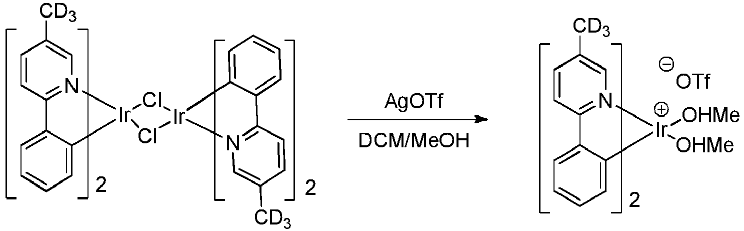

The reaction mixture was filtered through Celite® and the Celite® washed with dichloromethane. The filtrate was evaporated leaving a green solid product, Iridium(III) triflate complex (8.7 g, 92%).

**Synthesis of Compound 2.** To a 500 mL round bottom flask was added the Iridium(III) triflate complex (8.7 g, 11.63 mmol), 4-(Methyl-*d3*)-2,5-diphenylpyridine (8.67 g, 34.9 mmol), 160 mL ethanol, and 160 mL methanol. The reaction mixture was heated at 105 °C overnight under nitrogen.

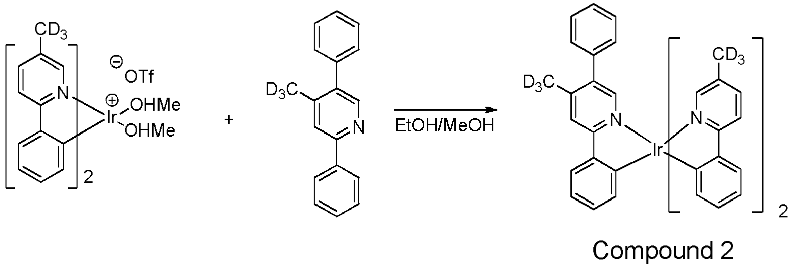

Celite® (27 g) was added to the reaction mixture and stirred. The mixture was poured onto a silica gel plug. The silica gel plug was washed with ethanol and hexane and then the product eluted with dichloromethane. The crude product was purified by column chromatography to give 4.48 g (49%) of desired product.

### Synthesis of Compound 10 (not claimed)

**Synthesis of Compound 10.** To a 2L 3-neck round bottom flask was added the Iridium(III) triflate complex from the Compound 2 synthesis (above)(23.545 g, 31.5 mmol), 2,4-diphenylpyridine (21.85 g, 94 mmol), 450 mL ethanol, and 450 mL methanol. The reaction mixture was heated to reflux overnight at 105 °C under nitrogen.

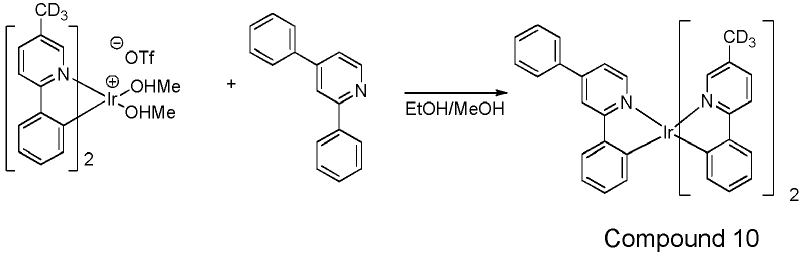

The reaction mixture was cooled to room temperature. A solid settled at the bottom and most of the dark colored liquid was decanted off. Ethanol and Celite® was added and the mixture was stirred and poured on top of a silica gel plug. The plug was washed with ethanol and hexane. The product was eluted with dichloromethane. The crude was purified by column chromatography to give 4.16 g (18%) desired product.

### Synthesis of Compound 212 (not claimed)

**Synthesis of Compound 212.** To a 200 mL round bottom flask was added the Iridium(III) triflate complex from the Compound 2 synthesis (1.56 g, 1.73 mmol), 5-methyl-*d3-*2-phenylpyridine (0.896 g, 5.20 mmol), 20 mL ethanol, and 20 mL methanol. The reaction mixture was heated at 105 °C overnight under nitrogen.

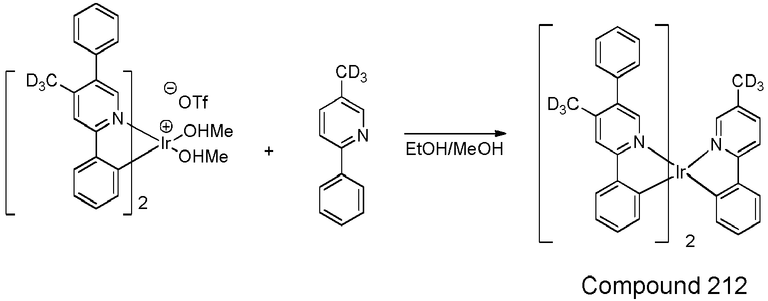

Celite® was added to the reaction mixture and stirred. The Celite® mixture was added to a Celite® plug and the Celite® was washed with methanol. The Celite® was washed with dichloromethane to recover product. The product was further purified by column chromatography to give desired product (0.64 g, 43%).

### Synthesis of Compound T1

**Synthesis of Compound T1.** To a 500 mL round bottom flask was added the Iridium(III) triflate complex from the Compound 2 synthesis (6.0 g, 6.67 mmol), 4-(Methyl-*d3*)-2,5-diphenylpyridine (4.97 g, 20.0 mmol), 100 mL ethanol, and 100 mL methanol. The reaction mixture was heated at 105 °C overnight under nitrogen.

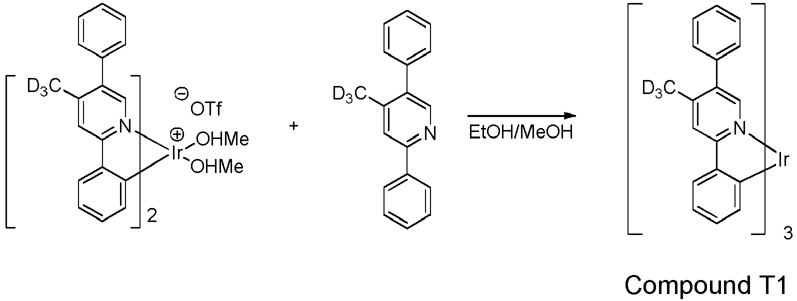

Celite® (18 g) was added to the reaction mixture and stirred. The Celite® mixture was added to a Celite® plug. The Celite® was washed with methanol and hexane and then dichloromethane to collect product. The solid was purified by column chromatography eluting with 40 to 100% dichloromethane/hexane (4.39 g, 70%).

### Synthesis of Compound 54 (not claimed)

***Synthesis of 5-bromo-4-methyl-2-phenylpyridine.*** A mixture of 2,5-dibromo-4-methylpyridine (20.55 g, 82 mmol), phenylboronic acid (10.49 g, 86 mmol), and potassium carbonate (16.98 g, 123 mmol) in 150 mL of DME and 75 mL of H₂O was bubbled with N₂ for 20 min. Pd(PPh₃)₄ (0.946 g, 0.819 mmol) was then added, and the mixture was heated to reflux under N₂ for 24 h.

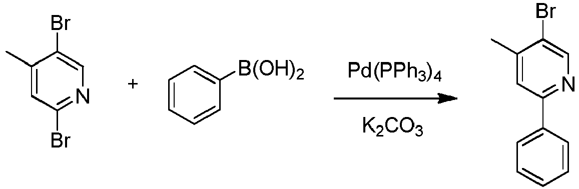

After normal work up, the crude product was purified by column using 2% ethyl acetate in hexanes as solvent to give 5-bromo-4-methyl-2-phenylpyridine (14 g, 56.4 mmol, 68.9 % yield).

***Synthesis of 2-phenyl-4-methyl-5-methyl-d3-pyridine.*** 5-bromo-4-methyl-2-phenylpyridine (9.5 g, 38.3 mmol) was dissolved in 100 mL of THF under nitrogen. The solution was cooled to -78 °C. Butyllithium (2.5 M, 15.32 ml, 38.3 mmol) was added to the solution in a dropwise manner.

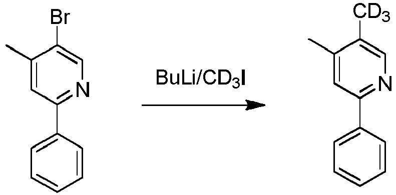

The color turned to orange and a precipitate formed. The reaction mixture was kept at the temperature for 0.5 h. Iodomethane-d3 (8.33 g, 57.4 mmol) was then added. The reaction was warmed to room temperature overnight. Water was then added to the reaction. The mixture was extracted with ethyl acetate, washed with brine, and dried over MgSO₄. The solvent was then evaporated. The crude was purified by column using 5% to 10% ethyl acetate and hexanes as solvent to give 4.1 g (58% yield) of product.

***Synthesis of Iridium Complex Dimer.*** Iridium chloride (4.96 g, 14.06 mmol) and 2-**phenyl-4-methyl-5-methyl-d3-pyridine** (5.5 g, 29.5 mmol) were mixed in 80 mL of 2-ethoxyethanol and 27 mL of water.

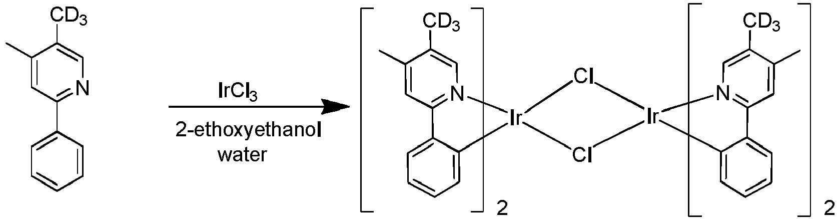

The mixture was purged with nitrogen for 20 min and then heated to reflux for 60 h. After cooling, the solid was filtered and washed with methanol and hexanes and dried to give an iridium complex dimer (7.5 g, 6.27 mmol, 89 % yield).

***Synthesis of Iridium-Triflate Intermediate.*** The iridium-complex dimer (7.5 g, 6.27 mmol) was mixed in 200 mL of dichloromethane. Silver triflate (3.38 g, 13.16 mmol) was dissolved in 50 mL of methanol and then added to the dimer mixture.

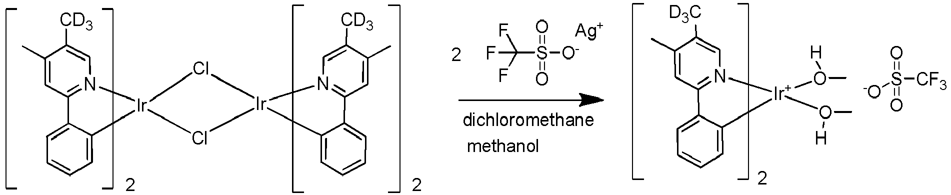

The solution was stirred for 3 h. The reaction mixture was filtered through a Celite® pad. The solvent was evaporated to give the iridium-triflate intermediate shown above (9.5 g, 12.24 mmol, 98 % yield).

***Synthesis of Compound 54.*** The iridium-triflate intermediate (2.3 g, 2.96 mmol) and 2,4-diphenylpyridine (2.74 g, 11.86 mmol) were mixed in 50 mL of ethanol and 50 mL of methanol.

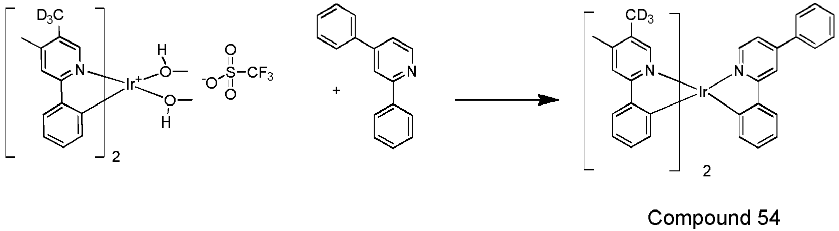

The mixture was heated to 65 degrees (oil bath temperature) for 3 days. Celite® (2g) was added to the reaction and the reaction was filtered through a Celite® plug. The product was washed with ethanol and hexanes. The solid was then dissolved with DCM. The solid was run through a silica gel plug to give 2 g of Compound 54.

### Synthesis of Compound T14

***Synthesis of 2, 5-diphenyl-d5-4-ethylpyridine.*** 2,5-diphenyl-4-d3-methyl pyridine (5.0 g, 20.13 mmol) was dissolved in 100 ml THF and cooled to <-60°C using a dry ice/acetone bath. A 2.0 M solution of lithium diisopropyl amide (25.2 ml, 50.3 mmol) was added in portions via syringe to give a white suspension.

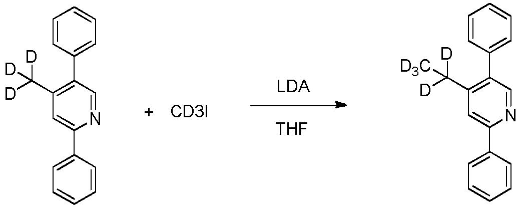

The reaction was warmed to room temperature. After 45 minutes, the dark red solution was cooled in a wet ice/acetone bath <0°C. Methyl iodide-d3 (19.08 ml, 201 mmol) was added to the reaction. The reaction was stirred overnight. GC/MS indicated the reaction was complete the next morning. The reaction was quenched with 7 ml deuterated water. The crude was purified by column chromatography to give 4.43 g (83% yield) of desired product.

***Synthesis of Compound T14.*** The iridium triflate intermediate from the synthesis of Compound 54 (2.93 g, 3.14 mmol), above, and 2, 5-diphenyl-4-d5-ethyl pyridine (2.493 g, 9.43 mmol) were dissolved in 70 ml.

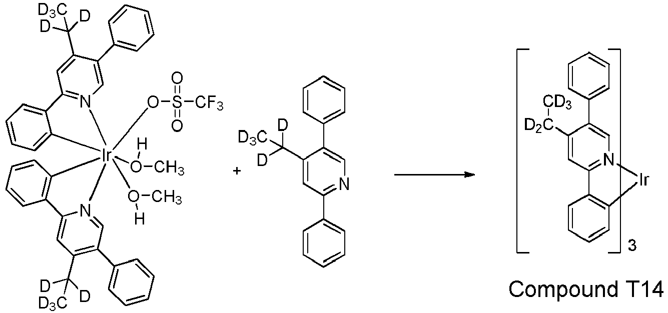

The reaction was heated to reflux overnight. The solid was filtered through a Celite® pad, then dissolved with dichloromethane. The crude was purified by column chromatography using hexanes and dichloromethane as solvent to give 1.7 g of desired product.

### Device Examples

All example devices were fabricated by high vacuum (<10⁻⁷ Torr) thermal evaporation. The anode electrode was 1200 Å of indium tin oxide (ITO). The cathode consisted of 10 Å of LiF followed by 1,000 Å of Al. All devices were encapsulated with a glass lid sealed with an epoxy resin in a nitrogen glove box (<1 ppm of H₂O and O₂) immediately after fabrication. A moisture getter was incorporated inside the package.

The organic stack of the device examples consisted of sequentially, from the ITO surface, 100 Å of Compound A or B as the hole injection layer (HIL), 300 Å of 4,4'-bis[N-(1-naphthyl)-N-phenylamino]biphenyl (α-NPD) as the hole transporting layer (HTL), 300 Å of the inventive compounds doped with Compound C as host, with 8 - 10 wt % of the iridium phosphorescent compound as the emissive layer (EML), 50 or 100 Å of Compound C as a blocking layer (BL), 400 or 450 Å of Alq (tris-8-hydroxyquinoline aluminum) as the ETL. The comparative Examples were fabricated similarly to the Device Examples except that Compound B was used as the emitter in the EML

The device results and data are summarized in Tables 1 and 2 from those devices. As used herein, NPD, Alq, Compound B and Compound C have the following structures:

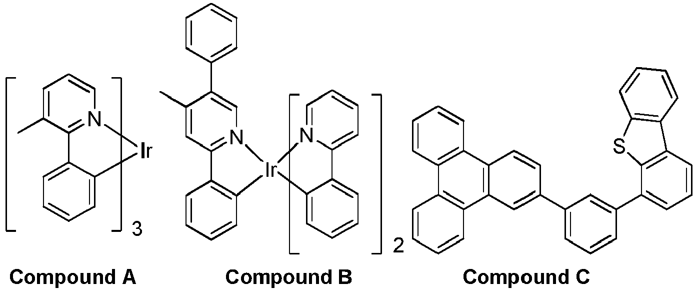

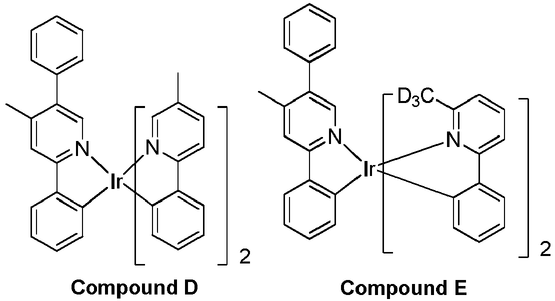

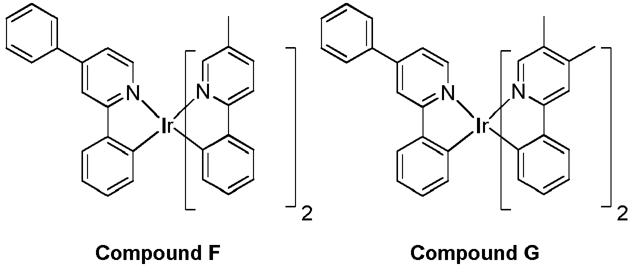

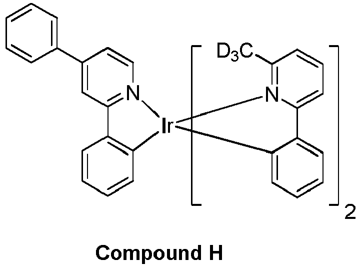

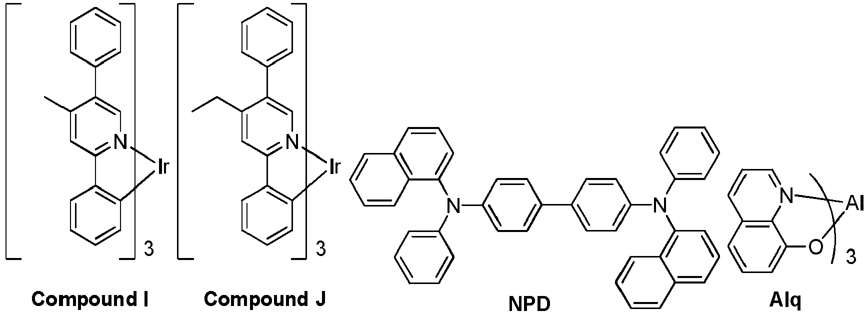

The structures are summarized in Table 1, while the test results are summarized in Tables 2, 3 and 4. Examples 5 and 6 are according to the claimed invention.

**Table 1 device Structures of Inventive Compound and Comparative Compound**

| **Example** | **HIL** (100 Å) | **HTL** (300 Å) | **EML** (300 Å, doping %) | **BL** | **ETL** |
|---|---|---|---|---|---|
| Example 1 | Compound B | NPD | Compound 2 (10%) | Compound C (50 Å) | Alq (450 Å) |
| Example 2 | Compound B | NPD | Compound 212 (10%) | Compound C (50 Å) | Alq (450 Å) |
| Example 3 | Compound B | NPD | Compound 10 (10%) | Compound C (50 Å) | Alq (450 Å) |
| Example 4 | Compound B | NPD | Compound 54 (10%) | Compound C (50 Å) | Alq (450 Å) |
| Example 5 | Compound B | NPD | Compound T1 (8%) | Compound C (50 Å) | Alq (450 Å) |
| Example 6 | Compound B | NPD | Compound T14 (10%) | Compound C (50 Å) | Alq (450 Å) |
| Comparative Example 1 | Compound A | NPD | Compound D (7%) | Compound C (100 Å) | Alq (400 Å) |
| Comparative Example 2 | Compound A | NPD | Compound E (7%) | Compound C (100 Å) | Alq (400 Å) |
| Comparative Example 3 | Compound B | NPD | Compound F (8%) | Compound C (50 Å) | Alq (450 Å) |
| Comparative Example 4 | Compound B | NPD | Compound G (7%) | Compound C (50 Å) | Alq (450 Å) |
| Comparative Example 5 | Compound B | NPD | Compound H (10%) | Compound C (50 Å) | Alq (450 Å) |
| Comparative Example 6 | Compound A | NPD | Compound I (10%) | Compound C (100 Å) | Alq (400 Å) |
| Comparative Example 7 | Compound A | NPD | Compound J (10%) | Compound C (100 Å) | Alq (400 Å) |

**Table 2 VTE device results**

| | **x** | **y** | **λₘₐₓ (nm)** | **Relative Voltage** | **Relative EQE** | **Relative Initial Luminance** | **Relative LT80** |
|---|---|---|---|---|---|---|---|
| Example 1 | 0.355 | 0.607 | 530 | 1.0 | 0.9 | 0.8 | 1.3 |
| Example 2 | 0.373 | 0.599 | 532 | 1.1 | 0.8 | 0.8 | 1.2 |
| Comparative Example 1 | 0.358 | 0.607 | 528 | 1.0 | 1.0 | 1.0 | 1.0 |
| Comparative Example 2 | 0.342 | 0.616 | 526 | 0.9 | 0.9 | 0.9 | 0.6 |

**Table 3 VTE device results**

| | **x** | **y** | **λₘₐₓ (nm)** | **Relative Voltage** | **Relative EQE** | **Relative Initial Luminanec** | **Relative LT80** |
|---|---|---|---|---|---|---|---|
| Example 3 | 0.456 | 0.533 | 562 | 1.0 | 1.1 | 1.1 | 1.6 |
| Example 4 | 0.478 | 0.515 | 566 | 1.0 | 1.1 | 1.1 | 2.7 |
| Comparative Example 3 | 0.448 | 0.540 | 558 | 1.0 | 1.0 | 1.0 | 1.0 |
| Comparative Example 4 | 0.480 | 0.512 | 570 | 1.04 | 1.0 | 1.0 | 2.4 |
| Comparative Example 5 | 0.420 | 0.564 | 552 | 1.0 | 1.0 | 1.0 | 1.1 |

**Table 4 VTE device results**

| | **x** | **y** | **λₘₐₓ (nm)** | **Relative Voltage** | **Relative EQE** | **Relative Initial Luminance** | **Relative LT80** |
|---|---|---|---|---|---|---|---|
| Example 5 | 0.359 | 0.609 | 528 | 0.9 | 1.0 | 0.9 | 1.4 |
| Example 6 | 0.350 | 0.614 | 528 | 1.0 | 1.1 | 0.9 | 1.6 |
| Comparative Example 6 | 0.340 | 0.622 | 528 | 1.0 | 1.0 | 1.0 | 1.0 |
| Comparative Example 7 | 0.358 | 0.611 | 530 | 1.1 | 1.1 | 1.1 | 1.1 |

Tables 2, 3 and 4 summarize the performance of the devices. The CIE coordinates, driving voltage (V), and external quantum efficiency (EQE) were measured at 1000 nits, while the lifetime (LT_{80%}) was defined as the time required for the device to decay to 80% of its initial luminance under a constant current density of 40 mA/cm². Devices with similar colors were grouped in different device results tables for meaningful comparison. The benefit of having a deuterated methyl group on the 5^{th} position of the 2-phenylpyridine ligand can be clearly seen from the device data. All the devices with the inventive compounds showed similar voltage and EQE, but exhibited extended device lifetime compared to comparative examples. The inventive compounds not only showed device lifetime advantages over non-deuterated compounds with the same substitution pattern, but also showed better performance over deuterated methyl substitution at other positions, such as the 6^{th} position on the pyridine (Compound E and Compound H).

## Claims

1. A homoleptic, tris-iridium complex including deuterated alkyl groups, the complex being selected from the group consisting of: 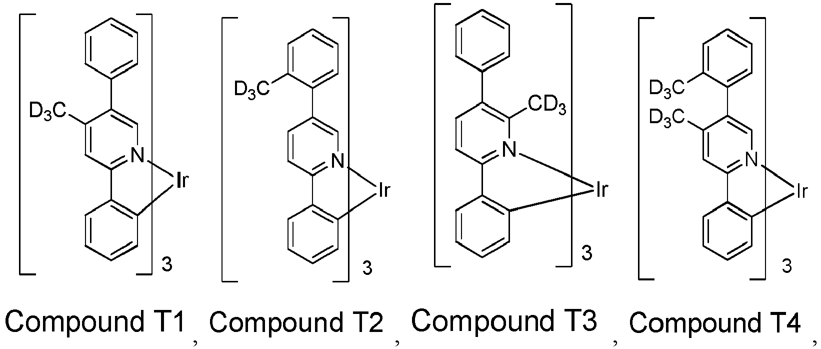 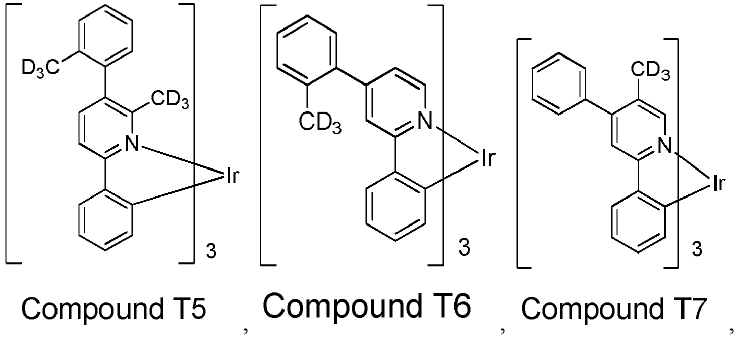 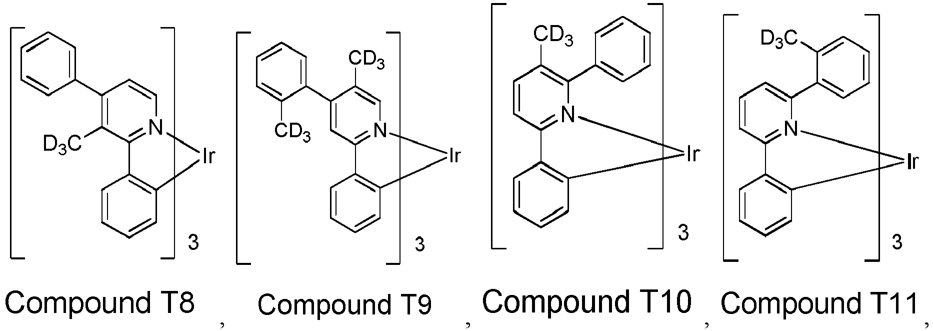 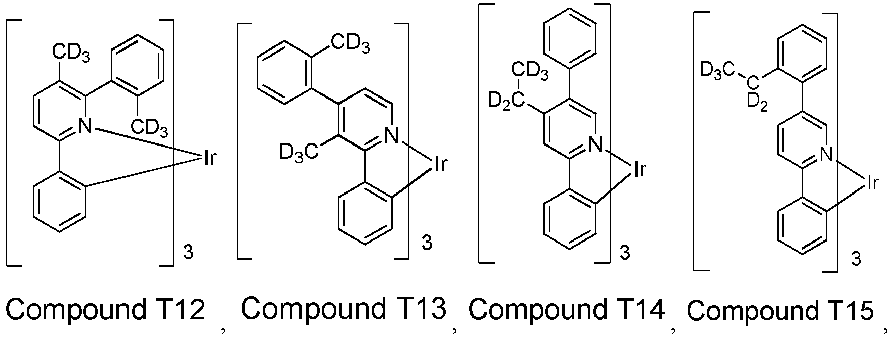 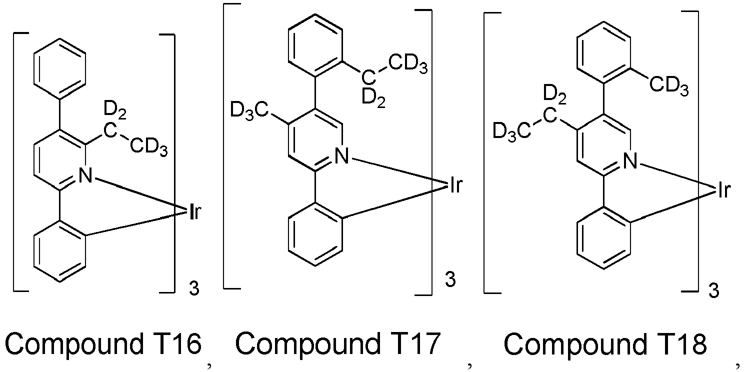 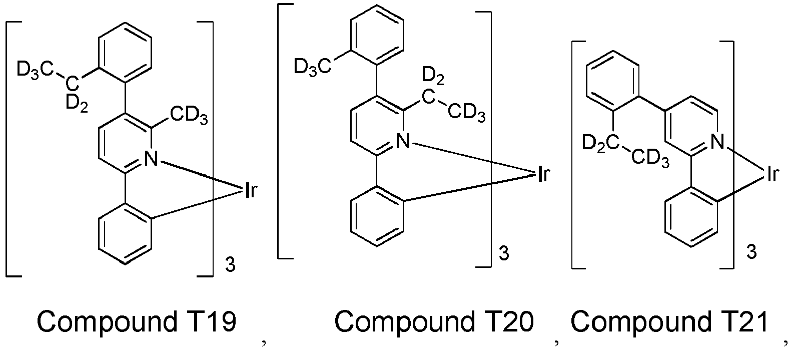 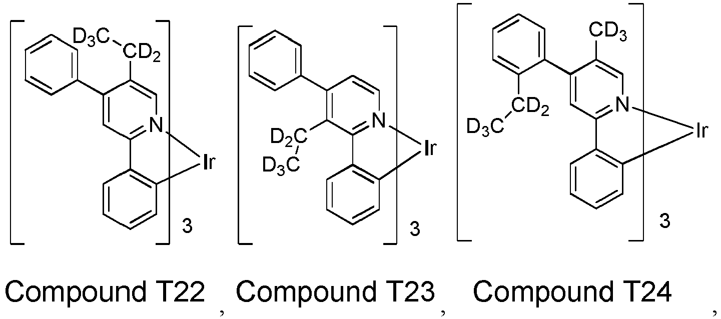 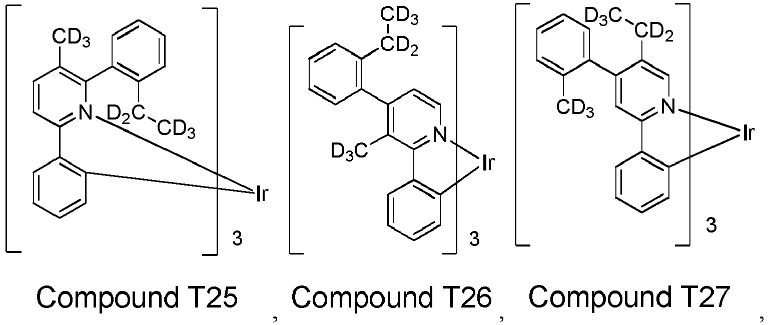 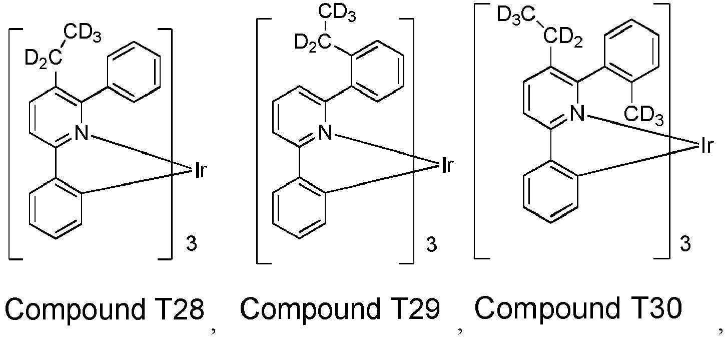 and

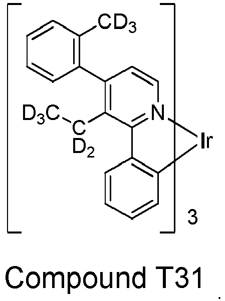

2. A first device comprising a first organic light emitting device, further comprising:
an anode;
a cathode; and
an organic layer, disposed between the anode and the cathode, comprising a compound as defined in claim 1.

3. The first device of claim 2, wherein the device is incorporated into one of a consumer product, flat panel display, computer monitor, medical monitor, television, billboard, lighting panel or light for interior or exterior illumination and/or signaling, heads up display, fully transparent display, flexible display, laser printer, telephone, cell phone, personal digital assistant (PDA), laptop computer, digital camera, camcorder, viewfinder, micro-display, vehicle, a large area wall, theater or stadium screen, or a sign.

4. The first device of claim 2, wherein the organic layer is an emissive layer and the compound is an emissive dopant.

5. The first device of claim 2, wherein the organic layer is an emissive layer and the compound is a non-emissive dopant.

6. The first device of claim 2, wherein the organic layer further comprises a host.

7. The first device of claim 6, wherein the host comprises a triphenylene containing benzo-fused thiophene or benzo-fused furan;
wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, An, Ar₁-Ar₂, CₙH₂ₙ-Ar₁, or no substitution;
wherein n is from 1 to 10; and
wherein Ar₁ and Ar₂ are independently selected from the group consisting of benzene, biphenyl, naphthalene, triphenylene, carbazole, and heteroaromatic analogs thereof.

8. The first device of claim 6, wherein the host comprises a compound selected from the group consisting of: carbazole, dibenzothiphene, dibenzofuran, dibenzoselenophene, azacarbazole, aza-dibenzothiophene, aza-dibenzofuran, and aza-dibenzoselenophene.

9. The first device of claim 6, wherein the host is selected from the group consisting of: 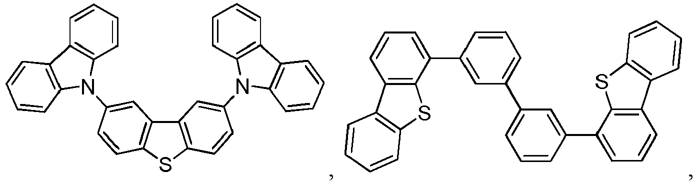 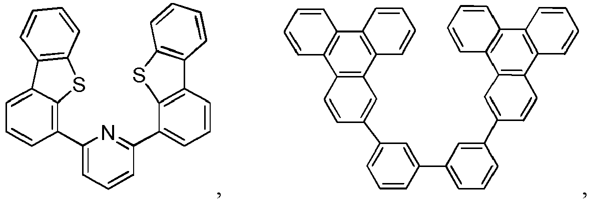 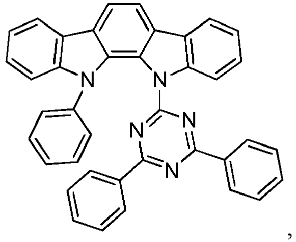 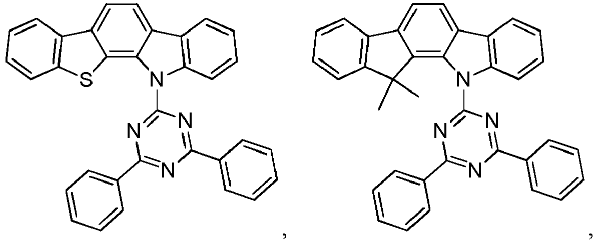 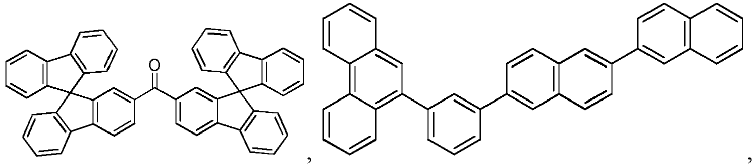 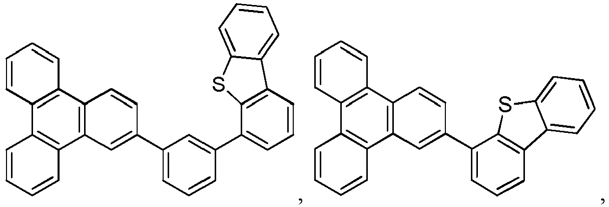 and combinations thereof.

10. The first device of claim 6, wherein the host comprises a metal complex.

11. A use of a compound as defined in claim 1, as an emitter in an organic light emitting device.

12. A use of a compound as defined in claim 1, in an organic solar cell, an organic photodetector, or an organic transistor.

13. A formulation comprising a compound according to claim 1.

## Patentansprüche

1. Ein homoleptischer tris-Iridium-Komplex umfassend deuterierte Alkylgruppen, wobei der Komplex ausgewählt ist aus der Gruppe bestehend aus: 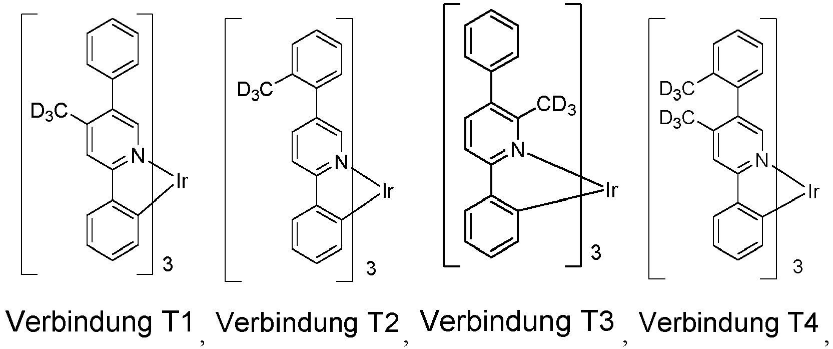 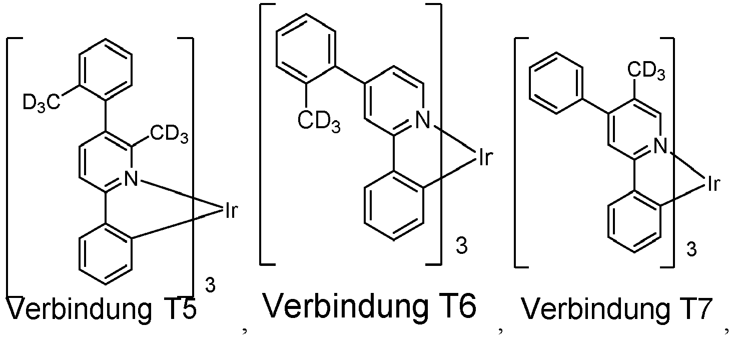 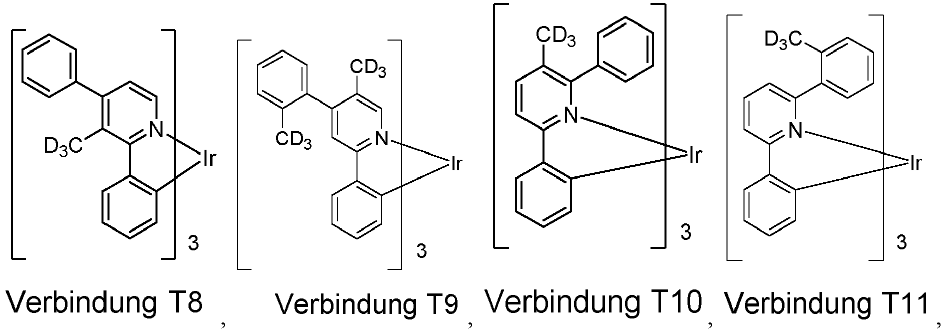 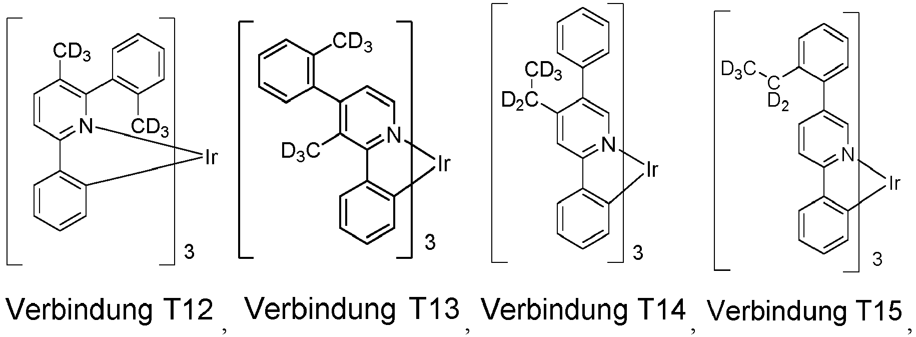 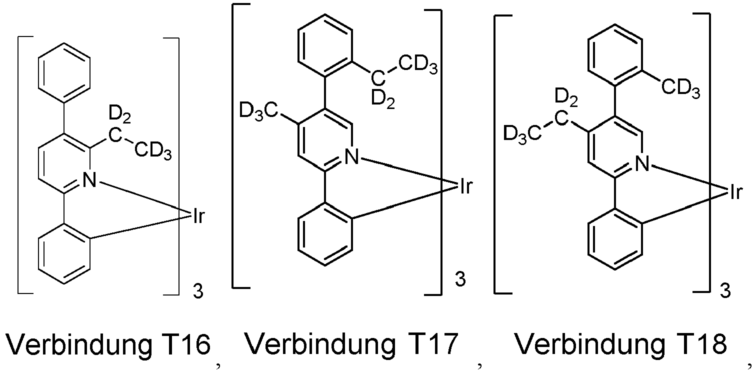 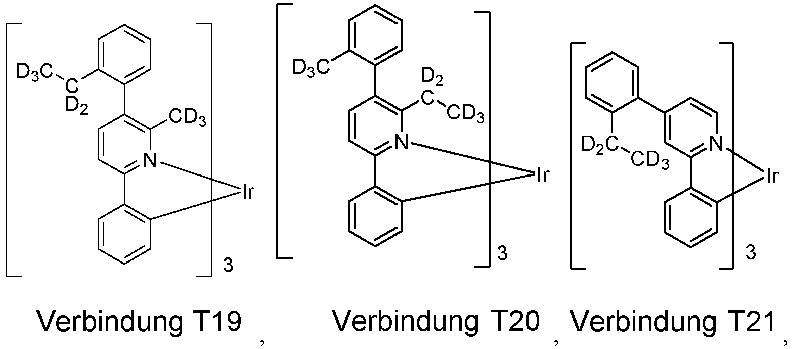 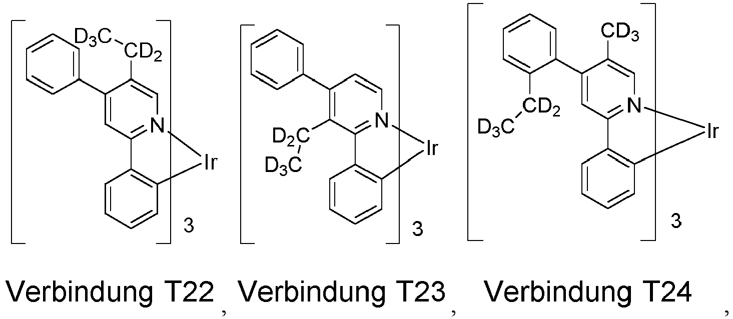 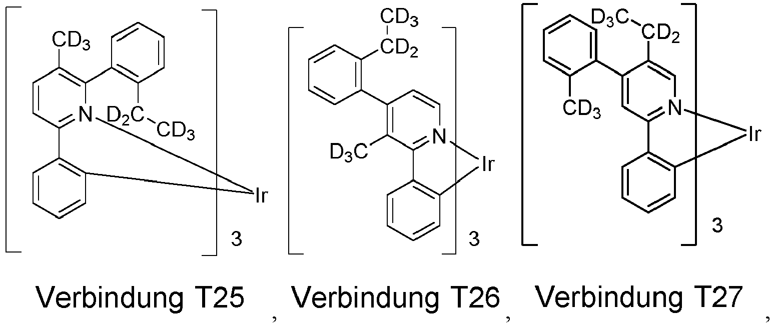 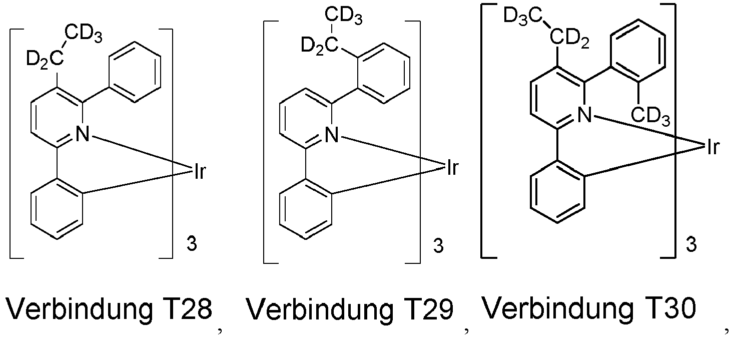 und

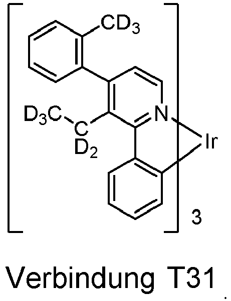

2. Eine erste Vorrichtung umfassend eine erste organische Licht emittierende Vorrichtung, ferner umfassend:
eine Anode;
eine Kathode; und
eine organische Schicht, angeordnet zwischen der Anode und der Kathode, umfassend eine Verbindung wie in Anspruch 1 definiert.

3. Die erste Vorrichtung nach Anspruch 2, wobei die Vorrichtung eingebaut ist in ein Konsumentenprodukt, Flachbildschirm, Computermonitor, medizinischer Monitor, Fernseher, Werbetafel, Beleuchtungsleiste, oder Licht für interne oder externe Beleuchtung und/oder Signalgebung, ein Heads-up Display, vollständig transparenter Bildschirm, flexibler Bildschirm, Laserdrucker, Telefon, Mobiltelefon, persönlicher Digitalassistent (PDA), Laptopcomputer, Digitalkamera, Camcorder, Sucher, Mikro-Display, Fahrzeug, eine großflächige Leinwand, Theater oder Stadionbildschirm, oder ein Schild.

4. Eine erste Vorrichtung nach Anspruch 2, wobei die organische Schicht eine emittierende Schicht und die Verbindung ein emittierender Dotierstoff ist.

5. Die erste Vorrichtung nach Anspruch 2, wobei die organische Schicht eine emittierende Schicht und die Verbindung ein nicht emittierender Dotierstoff ist.

6. Die erste Vorrichtung nach Anspruch 2, wobei die organische Schicht ferner einen Wirt umfasst.

7. Eine erste Vorrichtung nach Anspruch 6, wobei der Wirt ein Triphenylen enthaltendes Benzo-fusioniertes Thiophen oder Benzo-fusioniertes Furan umfasst;
wobei jeder Substituent in dem Wirt ein nicht fusionierter Substituent ist, der unabhängig ausgewählt ist aus der Gruppe bestehend aus CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, oder keine Substitution;
wobei n von 1 bis 10 ist; und
wobei Ar₁ und Ar₂ unabhängig ausgewählt sind aus der Gruppe bestehend aus Benzol, Biphenyl, Naphthalin, Triphenylen, Carbazol, und heteroaromatischen Analoga davon.

8. Die erste Vorrichtung nach Anspruch 6, wobei der Wirt eine Verbindung umfasst, die ausgewählt ist aus der Gruppe bestehend aus: Carbazol, Dibenzothiophen, Dibenzofuran, Dibenzoselenophen, Azacarbazol, Aza-dibenzothiophen, Aza-dibenzofuran, und Aza-dibenzoselenophen.

9. Die erste Vorrichtung nach Anspruch 6, wobei der Wirt ausgewählt ist aus der Gruppe bestehend aus: 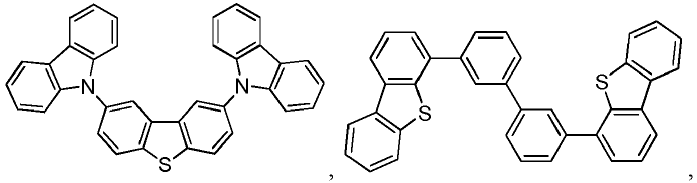 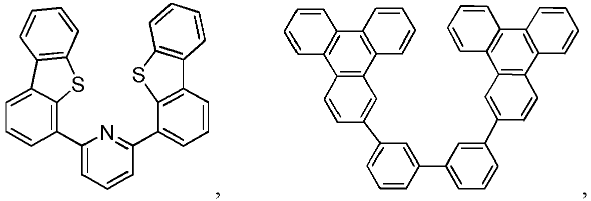 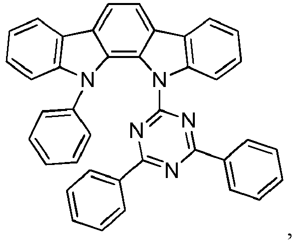 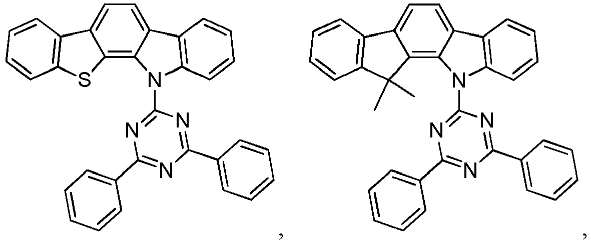 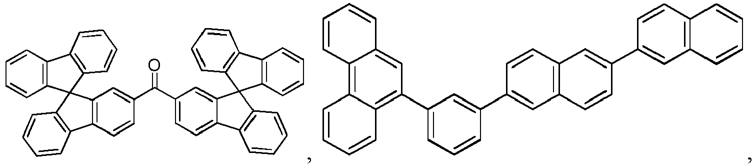 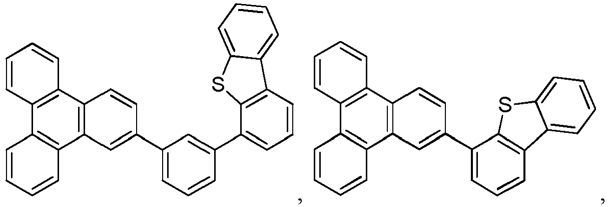 oder Kombinationen davon.

10. Die erste Vorrichtung nach Anspruch 6, wobei der Wirt einen Metallkomplex umfasst.

11. Die Verwendung einer Verbindung wie in Anspruch 1 definiert, als ein Emitter in einer organischen Licht emittierenden Vorrichtung.

12. Die Verwendung einer Verbindung wie in Anspruch 1 definiert, in einer organischen Solarzelle, einem organischen Photodetektor, oder einem organischen Transistor.

13. Eine Formulierung umfassend eine Verbindung gemäß Anspruch 1.

## Revendications

1. Complexe tris-iridium homoleptique incluant des groupes alkyle deutérés, le complexe étant choisi dans le groupe constitué par : 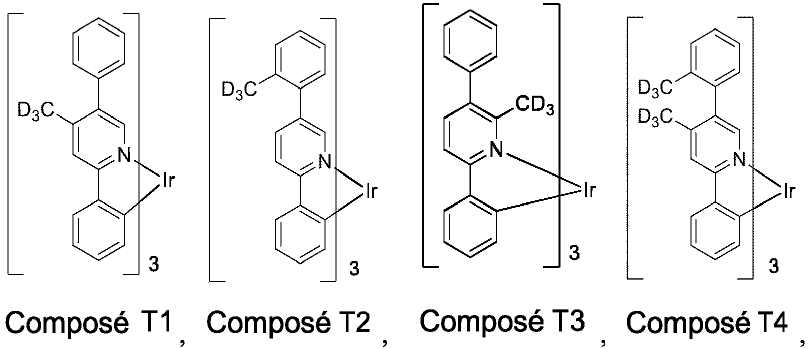 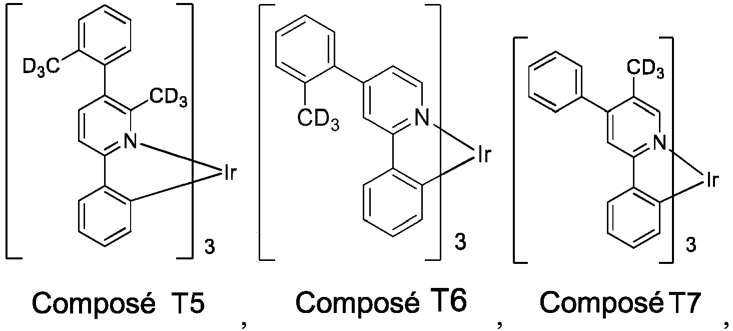 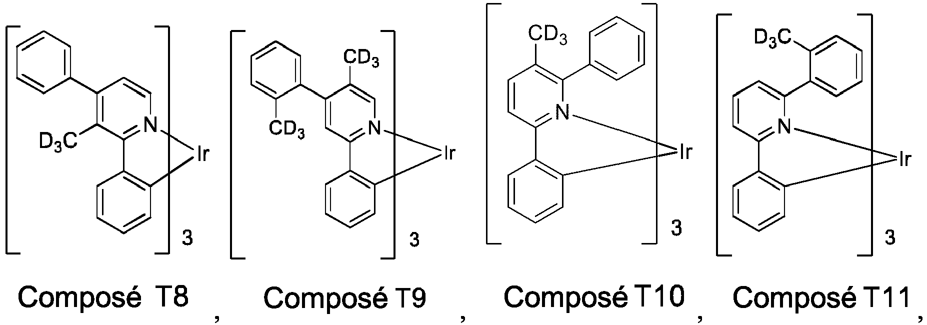 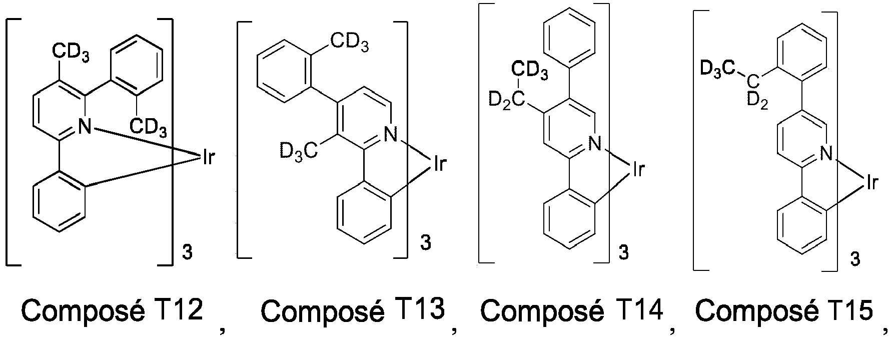 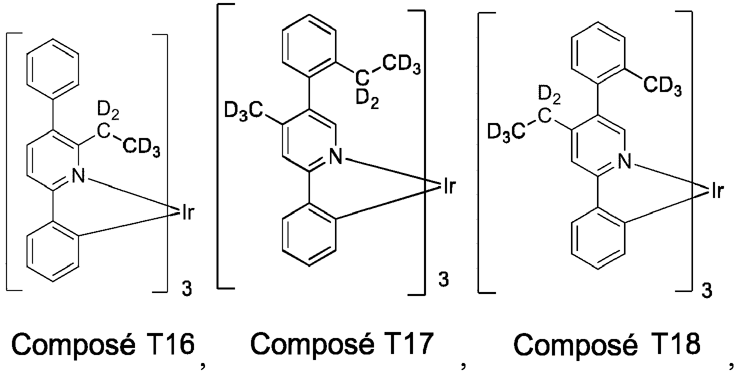 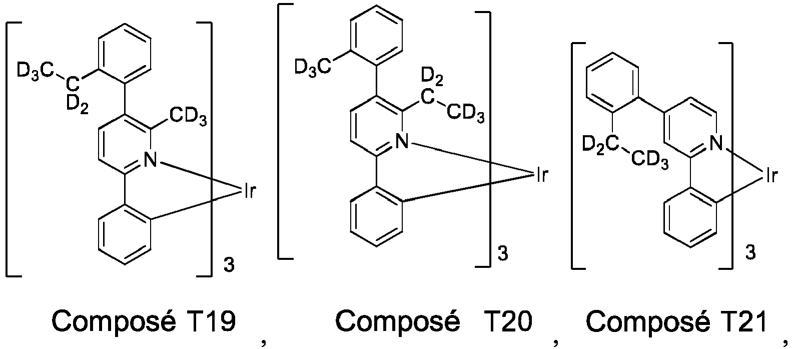 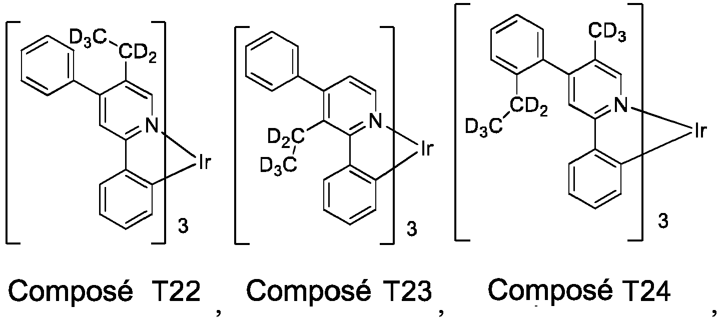 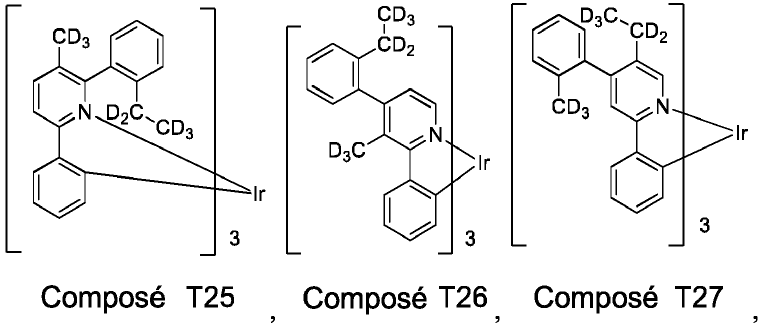 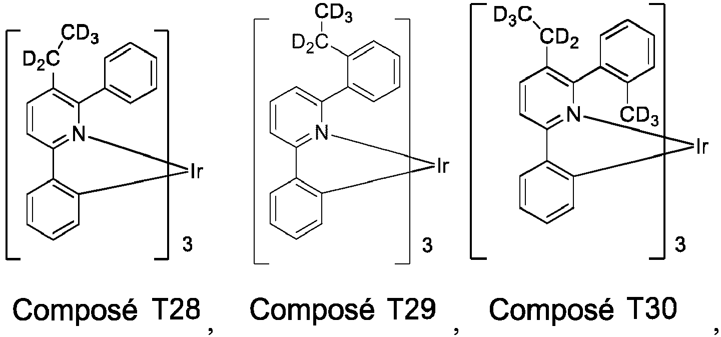 et

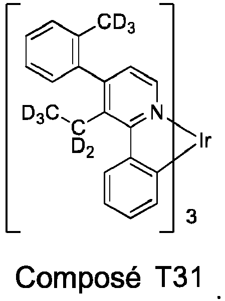

2. Premier dispositif comprenant un premier dispositif électroluminescent organique, comprenant en outre :
une anode ;
une cathode ; et
une couche organique, disposée entre l'anode et la cathode, comprenant un composé tel que défini dans la revendication 1.

3. Premier dispositif selon la revendication 2, où le dispositif est incorporé dans un élément parmi un produit de consommation, un écran plat, un moniteur d'ordinateur, un moniteur médical, un téléviseur, un panneau d'affichage, un panneau d'éclairage ou une lumière pour l'éclairage d'intérieur ou d'extérieur et/ou la signalisation, un affichage tête haute, un affichage totalement transparent, un affichage souple, une imprimante laser, un téléphone, un téléphone cellulaire, un assistant numérique personnel (PDA), un ordinateur portable, un appareil photo numérique, un caméscope, un viseur, un micro-écran, un véhicule, un mur d'images, un écran de cinéma ou de stade, ou un panneau.

4. Premier dispositif selon la revendication 2, où la couche organique est une couche émissive et le composé est un dopant émissif.

5. Premier dispositif selon la revendication 2, où la couche organique est une couche émissive et le composé est un dopant non émissif.

6. Premier dispositif selon la revendication 2, où la couche organique comprend en outre un hôte.

7. Premier dispositif selon la revendication 6, où l'hôte comprend un thiophène benzo-fusionné ou furane benzo-fusionné contenant du triphénylène ;
où tout substituant dans l'hôte est un substituant non fusionné indépendamment choisi dans le groupe constitué par CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, ou aucune substitution ;
où n va de 1 à 10 ; et
où Ar₁ et Ar₂ sont indépendamment choisis dans le groupe constitué par benzène, biphényle, naphtalène, triphénylène, carbazole, et des analogues hétéroaromatiques de ceux-ci.

8. Premier dispositif selon la revendication 6, où l'hôte comprend un composé choisi dans le groupe constitué par : carbazole, dibenzothiophène, dibenzofurane, dibenzosélénophène, azacarbazole, azadibenzothiophène, azadibenzofurane et azadibenzosélénophène.

9. Premier dispositif selon la revendication 6, où l'hôte est choisi dans le groupe constitué par : 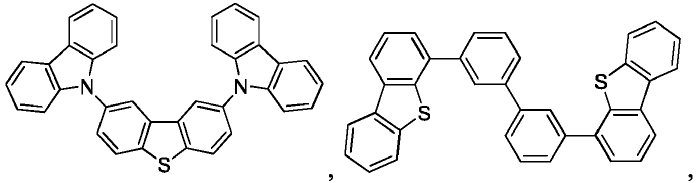 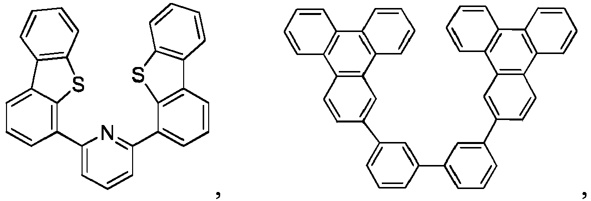 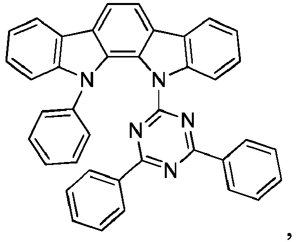 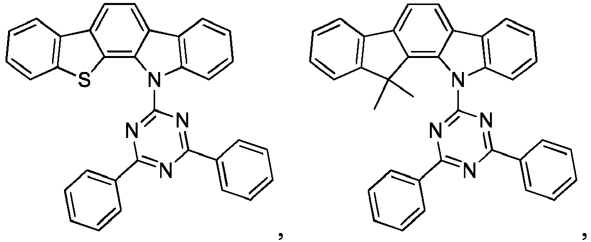 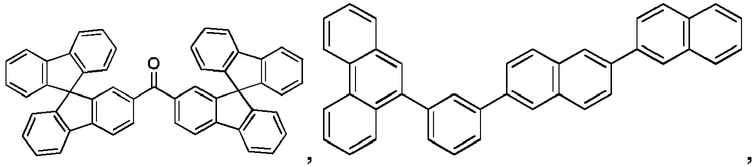 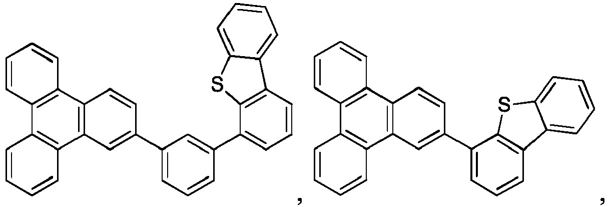 et des combinaisons de ceux-ci.

10. Premier dispositif selon la revendication 6, où l'hôte comprend un complexe métallique.

11. Utilisation d'un composé tel que défini dans la revendication 1, en tant qu'émetteur dans un dispositif électroluminescent organique.

12. Utilisation d'un composé tel que défini dans la revendication 1, dans une cellule solaire organique, un photodétecteur organique, ou un transistor organique.

13. Formulation comprenant un composé selon la revendication 1.
